# EUROPÄISCHE PATENTSCHRIFT

(11) **EP 1 192 704 B1**
(45) Veröffentlichungstag und Bekanntmachung des Hinweises auf die Patenterteilung: **11.10.2006**
(21) Anmeldenummer: 00952986.8
(22) Anmeldetag: 30.06.2000
(51) Int. Cl.: H02N 2/04, H02N 2/06, H01L 41/09, H01L 41/04

(54) **PIEZOELEKTRISCHER ANTRIEB, sowie System mit piezoelektrischem Antrieb und Schaltungsanordnung**
PIEZOELECTRIC DRIVE, and System with piezoelectric drive and drive circuit
ENTRAINEMENT PIEZOELECTRIQUE, et système avec entrainemanet piezoéléctrique et circuit

(30) Priorität: 30.06.1999 DE 19945042
(43) Veröffentlichungstag der Anmeldung: 03.04.2002
(73) Patentinhaber: Pi Ceramic GmbH, 07589 Lederhose (DE)
(72) Erfinder: WISCHNEWSKIY, Wladimir, D-07589 Münchenbernsdorf (DE)
(74) Vertreter: Kruspig, Volkmar
(86) Internationale Anmeldenummer: PCT/EP2000/006133
(87) Internationale Veröffentlichungsnummer: WO 2001/003282

(56) Entgegenhaltungen:
- DE-A- 19 648 726
- US-A- 5 166 572
- US-A- 5 714 833
- BEN-YAAKOV S ET AL: "A resonant driver for a piezoelectric motor" PROCEEDINGS OF THE THIRTY-NINTH INTERNATIONAL POWER CONVERSION CONFERENCE PCIM'99, NURNBERG, GERMANY, 22. - 24. Juni 1999, Seiten 173-178, XP000964532 ZM Commun. GMBH, Germany ISBN: 3-928643-22-3

## Beschreibung

Die Erfindung betrifft einen piezoelektrischen Antrieb, insbesondere piezoelektrischen Motor zur Erzeugung kontinuierlicher oder schrittweiser Bewegungen, umfassend einen eine Friktionsoberfläche aufweisenden Läufer, ein mit dieser Oberfläche in Kontakt bringbares Antriebselement in Form eines piezoelektrischen Erregers, wobei der Erreger aus einem monolithischen, plattenförmigen, im wesentlichen rechteckigen, Elektrodenflächen aufweisenden piezoelektrischen Wandler besteht, eine äußere Befestigung, ein auf einer der Stirnseiten des piezoelektrischen Wandlers angeordnetes Friktionselement sowie eine Halterung für den piezoelektrischen Wandler und Mittel zum elastischen Anpressen des Friktionselements an die Friktionsoberfläche des Läufers. Weiterhin richtet sich die Erfindung auf ein System mit einer Schaltungsanordnung zum Betreiben eines piezoelektrischen Antriebs.

Piezoelektrische Motoren, welche Ständer und Rotor umfassen, und wobei der Ständer mindestens einen piezoelektrischen Schwinger aufweist, der gegen die Oberfläche des Rotors in Antriebsrichtung reibschlüssig andrückbar ist, sind bekannt. Der Schwinger besteht bekanntermaßen aus einem Piezoelement, das auf seinen parallelen Außenflächen Elektroden aufweist, die an eine Wechselspannungsquelle angeschlossen werden. Zum Stand der Technik hierzu sei beispielsweise auf die DE 25 30 045 C2 verwiesen.

Aus der europäischen Patentanmeldung EP 0 475 752 sind lineare piezoelektrische Motoren bekannt, welche funktionsseitig auf akustische Wanderwellen zurückgreifen. Derartige Motoren, wie auch in der US-PS 5,596,241 gezeigt, haben den Nachteil, daß diese nicht minaturisierbar sind, da die Mindestlänge des Wellenleiters ein ganzzahliges Vielfaches der Wellenlänge λ betragen muß. Weiterhin sind derartige Motoren konstruktiv aufwendig und technologisch schwer umzusetzen und daher teuer.

Weiterhin gehören piezoelektrische Motoren auf der Basis von stehenden Wellen zum Stand der Technik, wobei hier auf das US-Patent 5,714,833 verwiesen sei. Bei derartigen Motoren dient als Antriebselement ein auf die zweite Biege- und die erste Longitudinalmode der akustischen Schwingungen abgestimmter piezoelektrische Erreger. Der Erreger weist einen platten-förmigen piezoelektrischen, mit zwei Elektrodengruppen zur Erzeugung von Schwingungen versehenen Piezowandler auf, auf dessen Stirnseite ein Friktionselement angeordnet ist. Eine Querverschiebung des Erregers wird mit Hilfe einer speziellen Halterung begrenzt.
Die Friktionsoberfläche des Erregers wird mittels eines Anpreßbauteils, z.B. einer Feder elastisch an die korrespondierende Friktionsoberfläche des Läufers angepreßt.

Wie im US-Patent 5,714,833 gezeigt, werden das Bauteil zum Erzeugen der Anpreßkraft des Erregers und die Querhalterung des Erregers als voneinander getrennte Baugruppen ausgeführt. Die bekannte Querhalterung ist in Form von zwei starren und zwei elastischen Trägern ausgebildet, die sich an den Seiten des Piezowandlers befinden. Die elastischen Träger pressen den Piezowandler an die starren Träger, z.B. Bolzen, die in einem Hohlraum des Piezowandlers befindlich sind, womit eine entsprechende Fixierung in Querrichtung erreicht wird. Die starren Träger sind beispielsweise als konische Kunststoffelemente oder Kunststoffstifte ausgeführt, wobei die elastischen Träger aus gummiähnlichen Werkstoffen gefertigt sind. Das eigentliche Bauteil zum Anpressen des Erregers bzw. eines Friktionselements an die Oberfläche des Läufers besteht aus einer Feder, die sich von einer hinteren Gehäusewand gegen die zweite Stirnoberfläche des Piezowandlers abstützt.

Bei der oben beschriebenen Lehre der aus der US-PS 5,714,833 bekannten Lösung ist es von wesentlichem Nachteil, daß die beiden Trägertypen, die Halterung und das Anpreßbauteil des Erregers eine niedrige mechanische Güte und einen hohen Reibungskoeffizienten mit der Oberfläche des Piezowandlers besitzen. Aufgrund dieser Tatsache findet bei Betrieb eines derartig konstruierten Motors eine unerwünschte Erwärmung statt, und zwar aufgrund der inneren Reibung der Elemente als auch bezüglich der Reibung an den Oberflächen des schwingenden Wandlers. Eine unerwünschte Erwärmung des Piezowandlers verringert nicht nur den Wirkungsgrad des Motors, sondern führt auch zu einem instabilen Betrieb.

Ein weiterer wesentlicher Nachteil der bekannten Lösung, umfassend einen aus Kunststoffmaterialien und gummiartigen Werkstoffen bestehenden Träger, ist die einseitige, starre Befestigung, welche keine präzise Positionierung, insbesondere bei hohen Läufergeschwindigkeiten ermöglicht. Es wurde beobachtet, daß bei derartigen Motoren ein starker, einseitiger Auslauf des Läufers auftritt, welcher einige zehntel Mikrometer erreicht, was bei einer Vielzahl von Anwendungen unzulässig hoch ist. Von einem Präzisionsantrieb kann daher nicht gesprochen werden. Letztendlich belastet die Querhalterung und das Anpreßbauteil den Erreger mechanisch, womit seinem Resonanzsystem ein zusätzlicher aktiver Widerstand zugeführt wird. Dies wiederum erfordert eine Erhöhung der Erregerspannung bis hin zu 500 V, was wiederum spezielle Schutzmaßnahmen nach sich zieht. Weiterhin verschiebt sich der Frequenzbereich des optimalen Motorbetriebs bezüglich der mechanischen Resonanzfrequenz der Biegemode der Oszillatorschwingungen auf der Frequenzskala, so daß eine Frequenzstabilisierung des Arbeitspunkts mittels Phasenrückkopplung unmöglich wird.

Aus der DE 196 48 726 A1 ist ein piezoelektrisches Antriebselement mit mindestens einem in x-, y- und/oder z-Richtung beweglichen Schwinger aus piezoelektrischer Keramik oder aufgebrachten piezoelektrischen Erregern bekannt, wobei der mindestens eine Schwinger auf einem Schwingerhalter befestigt ist. Gemäß der dortigen Lösung wird der Schwingerhalter mittels Federlager, insbesondere Biegefedergelenken an einem Tragteil derart befestigt, daß die Bewegung des mindestens einen Schwingers bzw. des Schwingerhalters in y- und z-Richtung unterdrückbar ist, jedoch die gewünschte Bewegung in x-Richtung möglichst ungestört erfolgen kann. Nach DE 196 48 726 A1 sind Schwingerhalter, Biegefedergelenke und Tragteil einstückig aus monolithische Baugruppe ausgebildet.
Es hat sich jedoch gezeigt, daß die oben zitierte Anordnung für ein piezoelektrisches Antriebselement bei längerem Betrieb durch die wirkenden Kräfte im Bereich der Biegefedergelenke zur Materialermüdung neigt und daß im Übergangsbereich von Schwingerhalter zu Biegefedergelenk eine permanente Sollbruchstelle besteht.

Aus dem Vorgenannten ist es Aufgabe der Erfindung, einen weiterentwickelte piezoelektrischen Antrieb, insbesondere piezoelektrischen Motor zur Erzeugung kontinuierlicher oder schrittweiser Bewegungen anzugeben, wobei durch eine spezielle Halterung der Wirkungsgrad und die Langzeitstabilität des Antriebs verbessert werden sollen, so daß unter allen Umständen präzise Translationsbewegungen und Feinpositionierungen, z.B. für Mikroskop- oder Koordinatentische realisiert werden können. Weiterhin soll es mit der Erfindung gelingen, eine unerwünschte Erwärmung des Erregers zu vermeiden, so daß der Motorbetrieb stabilisiert werden kann.

Weiterhin ist es Aufgabe der Erfindung, ein System mit Schaltungsanordnung zum Betreiben eines piezoelektrischen Antriebs, insbesondere piezoelektrischen Motors vorzuschlagen, wo eine Stabilisierung des Arbeitspunkts des Motors bei gleichzeitig geringer Erregerspannung möglich wird.

Die Lösung der Aufgabe der Erfindung erfolgt hinsichtlich des piezoelektrischen Antriebs und der speziellen Halterung des piezoelektrischen Wandlers mit einem Gegenstand nach den Merkmalen des Patentanspruchs 1 und hinsichtlich des Systems mit einer Lehre mit den Merkmalen des Patentanspruchs 6, wobei die Unteransprüche jeweils mindestens zweckmäßige Ausgestaltungen und Weiterbildungen umfassen.

Der Grundgedanke der Erfindung hinsichtlich des piezoelektrischen Antriebs und der dort notwendigen Halterung besteht darin, daß diese so ausgeführt ist, daß die eigentliche Querhalterung des piezoelektrischen Wandlers oder Schwingers mit der Funktion zum elastischen Anpressen des Friktionselements an die Oberfläche des Läufers kombiniert ist.

Konkret sind zur Halterung des piezoelektrischen Wandlers sowie zum Erzeugen der gewünschten Anpreßkraft des Friktionselements jeweils am äußeren Knoten der Biegeschwindungsmode ein elastischer, den Wandler umgreifender Doppelrahmen mit Innen- und Außenrahmen angeordnet.

Der Innenrahmen ist jeweils mit den Längsschmalseiten des Wandlers und der Außenrahmen mit der äußeren Befestigung verbunden.

Außen- und Innenrahmen sind voneinander beabstandet und über Stege oder Brücken in Kontakt stehend. Die Doppelrahmen bestehen aus einem elastischen Material hoher Güte.

Bevorzugt besitzen die Doppelrahmen jeweils einen längs der Achsen symmetrischen Aufbau, wobei die Stege oder Brücken, Innen- und Außenrahmen verbindend, mittig angeordnet sind.

Da, wie vorstehend beschrieben, jeder Innenrahmen mit seinem Schmalseiten starr mit den Längsschmalseiten, d.h. den kleineren Seitenflächen des plattenförmigen piezoelektrischen Wandlers verbunden ist und jeder Außenrahmen starr mit der äußeren Befestigung, z.B. einem Gehäuse in Verbindung steht, und zwischen Innen- und Außenrahmen Überbrückungen vorhanden sind, wird jeder der beiden Doppelrahmen zu einem Biegeschwingungselement hoher Güte. Bei der vorgeschlagenen Konstruktion existieren keine gegenseitigen Bewegungen zwischen den vibrierenden oder schwingenden Oberflächen des piezoelektrischen Erregers und den starr mit diesem verbundenen Innenrahmenoberflächen, d.h. es existieren keine mechanischen Reibungsverluste.

Die Innenreibungsverluste der Doppelrahmen selbst sind außerordentlich niedrig, da die Rahmen aus Werkstoffen mit einer hohen mechanischen Güte gefertigt sind. Die Querhalterung des piezoelektrischen Erregers und die hiermit kombinierte Vorrichtung zum elastischen Anpressen des Erregers bzw. des dort befindlichen Friktionselements weist sehr geringe mechanische Verluste auf. Der Erreger, d.h. der Schwinger und die Doppelrahmenhalterungen bilden ein gemeinsames, mit niedrigen mechanischen Verlusten behaftetes Schwingungssystem. Der Träger erwärmt sich nicht und besitzt daher einen hohen Stabilitätsgrad im Betrieb. Aufgrund der wesentlich kleineren mechanischen Verluste ist der Wirkungsgrad des Motors höher als derjenige von bekannten Lösungen und es sind geringere Erregungsspannungen möglich.

Letztendlich besitzen die Innen- und Außenrahmen in ihren Querrichtungen eine hohe Starrheit, so daß Querverschiebungen des Erregers bei Positionierung des Läufers mit hohen Geschwindigkeiten ausgeschlossen werden können, so daß grundsätzlich eine Positionierpräzision gleich dem kleinsten Schwingungsschritt des Erregers möglich ist.

Zum Erhalt der gewünschten Eigenschaften des Erregers bzw. Schwingers in Verbindung mit seiner Halterung sind zwischen den Längsbreitseiten des Wandlers und dem jeweiligen Innenrahmen Abstandsspalte ausgebildet. Bevorzugt werden die Innenrahmen an den Längsschmalseiten des Wandlers stoffschlüssig, z.B. durch Kleben oder Löten oder dergleichen Verbindungsarten befestigt.

Bezüglich des Friktionselements für einen piezoelektrischen Antrieb zum Übertragen von Kräften zwischen Ständer und Läufer wird gemäß einem weiteren Grundgedanken der Erfindung auf eine Doppelschichtstruktur zurückgegriffen.

Der mit dem Wandler oder Erreger verbundene Teil der Schichtstruktur ist als harter, poröser Körper ausgebildet, wobei der mit den Läufern in Kontakt stehende Teil der Schichtstruktur aus einem abriebfesten, monolithischen Körper besteht. Beide der Schichten bzw. beide Körper sind durch Sintern miteinander verbunden.
In den Poren des mit dem Wandler verbundenen Teils der Schichtstruktur sind Füllstoffe zum Erhalt einer festen Verbindung zwischen der Wandleroberfläche und dem eigentlichen Friktionselement angeordnet oder eingebracht.

Als Füllstoffe kommen beispielsweise Epoxidharz und/oder niedrigschmelzende Gläser in Betracht. Bevorzugt ist die Grenzfläche der Doppelschichtstruktur im wesentlichen parallel zur Wandlerstirnseite verlaufend orientiert.

Das Friktionselement mit Doppelschichtstruktur kann sowohl als Quader, aber auch als flacher oder steiler Pyramidenstumpf oder konischer Körper ausgeführt sein.
Bei einer Ausführungsform nach Art eines Pyramidenstumpfs ist die Verbindungsoberfläche zwischen Friktionselement und Erreger vergrößert, so daß sich die hier resultierende Haftung erhöht und größere Kräfte übertragen werden können.

Hinsichtlich der Schaltungsanordnung zum Betrieben eines piezoelektrischen Antriebs, insbesondere piezoelektrischen Motors wird von einem Grund- oder Steuergenerator ausgegangen, der mit einem zweikanaligen Brückenleistungsverstärker zusammenwirkt. Ein erster Eingang des Leistungsverstärkers wird direkt am Ausgang des Grund- oder Steuergenerators angeschlossen, wobei der zweite Eingang über einen Phasenschieber mit dem Grundgenerator in Verbindung steht. In die Ausgangsdiagonale des Brückenleistungsverstärkers ist ein Filter sowie ein summierender Transformator eingeschleift, wobei die Sekundärwicklung des Transformators über einen Umschalter mit einer der an sich bekannten Elektrodenflächen des piezoelektrischen Wandlers kontaktiert ist.
Mit einer derartigen Schaltungsanordnung kann eine lineare Geschwindigkeitsregulierung des Antriebs bzw. des Motorbetriebs erreicht werden.

Bei einer weiteren Ausführungsform der Schaltungsanordnung zum Betreiben eines piezoelektrischen Antriebs ist zusätzlich ein Signalpegelwandler, ein Komparator und ein elektronischer Elektrodengruppenkommutator vorgesehen. Hierbei ist der Eingang des Signalpegelwandlers am Komparatoreingang und der Ausgang des Signalpegelwandlers am Phasensteuerungseingang des Phasenschiebers angeschlossen. Die Komparatorausgänge sind mit den Steuerungseingängen des Elektrodengruppenkommutators verbunden, wobei die Ausgänge des Kommutators an die jeweiligen Elektrodenflächen angeschlossen sind. Bei dieser Ausführungsform kann eine Ansteuerung des Motors im unipolaren Betrieb vorgenommen werden.

Weiterhin ist in einer Ausgestaltung vorgesehen, auf den piezoelektrischen Wandler oder Erreger einen Biegesensor zur Messung der Biegekomponenten der mechanischen Erregung anzuordnen, wobei der Biegesensor als dünne, einschichtige piezokeramische Platte ausgebildet ist. Die piezokeramische Platte des Biegesensors hat eine bidirektionale, auf ihre Querachse bezogene symmetrische, senkrechte Polarisation. Die Platte selbst ist starr auf der Oberfläche des piezoelektrischen Wandlers befestigt, und zwar bevorzugt im Mittelpunkt zwischen Mittel- und Seitenknoten der Biegemode der Schwingungen.

Bei dieser Ausführungsform besteht die Möglichkeit, ein Meßsignal zu erhalten, dessen Phasenänderung direkt proportional zur Veränderung der mechanischen Biegespannungen bzw. der Schwingungsgeschwindigkeit des Erregers ist.

Bei dieser Ausführungsform des piezoelektrischen Motors mit Biegesensor wird schaltungsanordnungsseitig ein Phasendetektor mit einem Referenzsignaleingang, einem Steuereingang und einem Ausgang vorgesehen. Der Grundgenerator besitzt einen Eingang zur elektrischen Steuerung der Erregungsfrequenz. Eine der Gruppen der Elektrodenflächen des Wandlers ist über eine Referenzsignalerzeugungseinrichtung am Referenzsignaleingang des Phasendetektors angeschlossen. Die Biegesensorelektroden sind mit dem Eingang des Referenzsignalerzeugers verbunden, dessen Ausgang mit dem Steuereingang des Phasendetektors kontaktiert ist. Der Ausgang des Phasendetektors wiederum ist am Eingang zur Ansteuerung der Erregungsfrequenz des Grundgenerators angeschlossen.

Bei dieser schaltungsseitigen Ausführungsvariante ist eine negative Frequenzrückkopplung vorgesehen, wodurch eine Stabilisierung des Motorbetriebs in einem breiten Temperaturbereich möglich wird.

Die Erfindung soll nachstehend anhand von Ausführungsbeispielen sowie unter Zuhilfenahme von Figuren näher erläutert werden.

Hierbei zeigen:
- Fig. 1: eine Prinzipdarstellung des piezoelektrischen Antriebs in einer Ausführungsform als Linearmotor;
- Fig. 2: eine Darstellung des grundsätzlichen Aufbaus des piezoelektrischen Wandlers oder Schwingers;
- Fig. 3: und 4 eine Darstellung des Aufbaus der Doppelrahmen in Seitenansicht sowie in Draufsicht;
- Fig. 5: und 6 eine Darstellung der Verbindung des Innenrahmens der Doppelrahmenanordnung mit dem plattenförmigen piezoelektrischen Wandler;
- Fig. 7: eine Draufsicht auf die Motorkonstruktion in der Ausführung als Linearantrieb;
- Fig. 8: eine Darstellung der resultierenden Kräfte, die am elastischen Doppelrahmen bei Betrieb des Motors entstehen;
- Fig. 9: und 10 Darstellungen von Schwingungsformen der Flächen des elastischen Doppelrahmens:
- Fig. 11: verschiedene Ausführungsvarianten hinsichtlich der geometrischen Gestaltung des Friktionselements;
- Fig. 12: eine Ausführungsform der Schaltungsanordnung zum Betreiben eines piezoelektrischen Antriebs einschließlich prinzipieller Darstellung des Wandlers mit Doppelrahmen-Halterung;
- Fig. 13: eine Darstellung des Erregungsverhaltens in Verbindung mit dem Verlauf von im wesentlichen sinusförmigen Ansteuerspannungen;
- Fig. 14: Erläuterungsdiagramme hinsichtlich der Funktionsweise der Schaltungsanordnung;
- Fig. 15: eine weitere Ausführungsform der Schaltungsanordnung zum Betreiben eines piezoelektrischen Antriebs mit Signalpegelwandler;
- Fig. 16: Erläuterungsdiagramme hinsichtlich der Funktionsweise der Schaltungsanordnung gemäß Ausführungsbeispiel;
- Fig. 17: eine Darstellung des prinzipiellen Aufbaus und der Anordnung des Biegesensors zur Bestimmung der Biegekomponenten der mechanischen Erregerschwingungen;
- Fig. 18: Erläuterungsdiagramme bezüglich der Arbeitsweise des Biegesensors und
- Fig. 19: eine weitere schaltungstechnische Ausführungsvariante zur Ansteuerung eines piezoelektrischen Antriebs mit piezoelektrischem Wandler als Biegesensor mit dem Ziel, den Motorbetrieb in einem breiten Temperaturbereich zu stabilisieren.

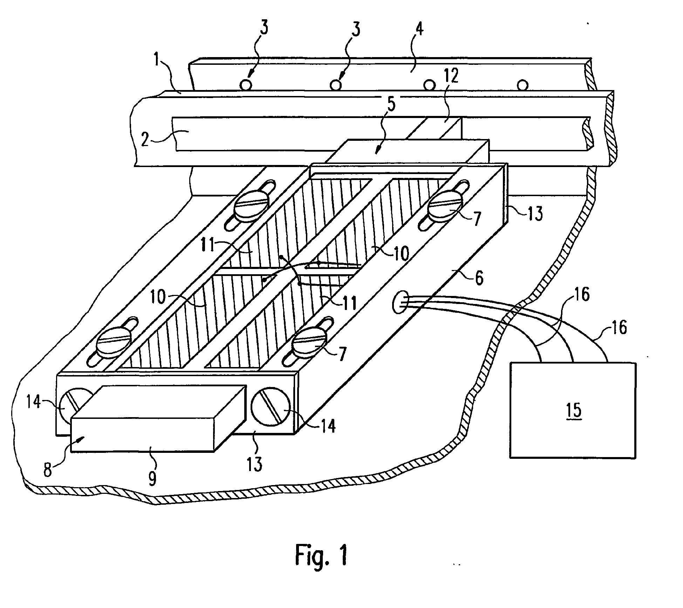

Der in der Fig. 1 dargestellte piezoelektrische Antrieb in einer Ausführungsform als Linearmotor umfaßt einen eine Friktionsoberfläche aufweisenden Läufer und ein mit dieser Oberfläche in Kontakt bringbares Antriebselement oder eine entsprechende Antriebseinheit. Das Antriebselement ist in Form eines piezoelektrischen Erregers ausgebildet, wobei der Erreger in an sich bekannter Weise aus einem monolithischen, plattenförmigen, im wesentlichen rechteckigen, Elektrodenflächen aufweisenden piezoelektrischen Wandler besteht. Darüber hinaus ist eine äußere Befestigung, die auch Teil eines Gehäuses sein kann, vorgesehen.

Auf einer der stirnseiten des piezoelektrischen Wandlers ist ein Friktionselement angeordnet und es ist eine spezielle Halterung für den piezoelektrischen Wandler vorgesehen, die gleichzeitig ein elastisches Anpressen des Friktionselements an die Friktionsoberfläche des Läufers ermöglicht.
Zur Halterung des piezoelektrischen Wandlers und zum Erzeugen der Anpreßkraft des Friktionselements ist jeweils am äußeren Knoten der Biegeschwingungsmode ein elastischer, den Wandler umgreifender Doppelrahmen mit Innen- und Außenrahmen angeordnet. Der Innenrahmen ist jeweils mit den Längsschmalseiten des Wandlers und der Außenrahmen mit der äußeren Befestigung, die Teil eines Gehäuses sein kann, verbunden. Der Außenrahmen und der Innenrahmen sind beabstandet und über Stege oder Brücken in Kontakt stehend. Der Doppelrahmen ist einstückig und kann aus einem metallischen Material durch Elektroerosion, Ätzen, Laserschneiden oder dergleichen Verfahren hergestellt werden.

Gemäß Fig. 1 ist ein Läufer 1 vorgesehen, welcher eine Friktionsoberfläche 2 besitzt. Der Läufer 1 stützt sich über Lager 3 gegen eine Trägerunterlage 4 ab.

Ein Antriebselement 5 ist elastisch mit dem Läufer 1, in Wirkverbindung stehend. Das Antriebselement 5 wird in einem Gehäuse 6 gehalten.

Das Gehäuse 6 wird beim gezeigten Beispiel mit Hilfe von Schrauben form- und kraftschlüssig auf der Trägerunterlage 4 befestigt. Langlochbohrungen im Gehäuse 6 ermöglichen eine Justage des Gehäuses und damit des Antriebselements 5 hinsichtlich der Lage zum Läufer 1.

Das Antriebselement 5 ist als piezoelektrischer Erreger 8 ausgeführt, der einen monolithischen, plattenförmigen piezoelektrischen Wandler 9 sowie zwei Elektrodenflächen oder Elektrodengruppen und ein auf der Stirnoberfläche 9 angeordnetes Friktionselement 12 enthält.

Die Querbefestigung des piezoelektrischen Wandlers 9 und das Anpressen des Friktionselements 12 an die Friktionsoberfläche 2 des Läufers 1 wird mit Hilfe spezieller Doppelrahmen 13 gewährleistet. Diese elastischen Doppelrahmen 13 umfassen den plattenförmigen piezoelektrischen Wandler 9 an beiden Enden, und zwar jeweils am äußeren Knoten der Biegeschwindungsmode.

Jede der Elektrodengruppen bzw. Elektrodenflächen 10, 11 wird über entsprechende Anschlußleitungen 16 mit einer Schaltungsanordnung zur Ansteuerung verbunden.

Die Doppelrahmen sind außenseits mit Hilfe von Schrauben 14 mit dem entsprechenden Teil des Gehäuses 6 lösbar verbunden.

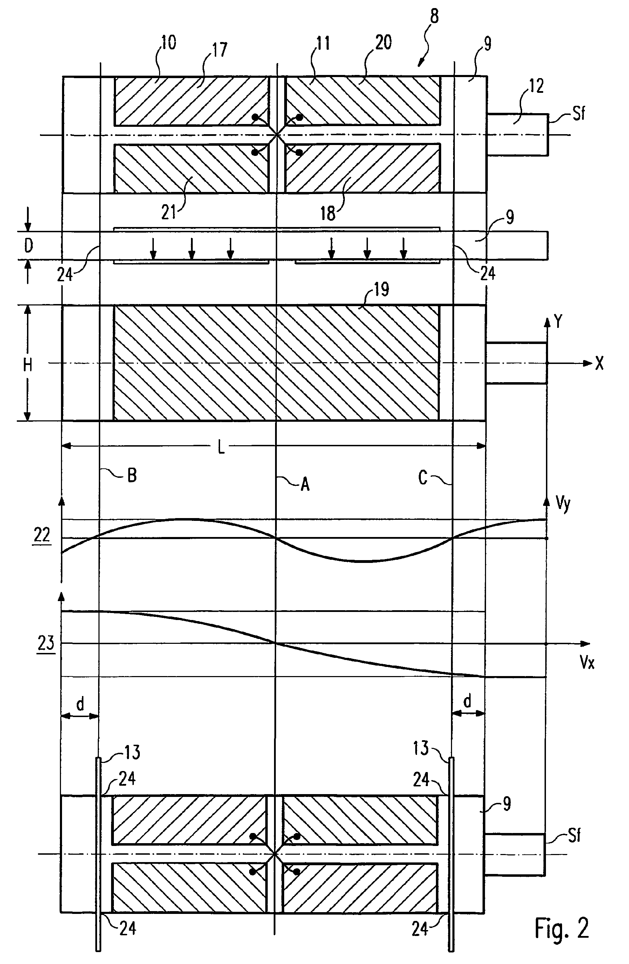

Der prinzipielle Aufbau des piezoelektrischen Erregers 8 ist mit der Fig. 2 dargestellt. Der Erreger 8 enthält den monolithischen, plattenförmigen, piezoelektrischen Wandler 9 mit Friktionselement 12. Auf den größeren Seitenflächen des Wandlers 9 befinden sich flächige Elektroden, die in Gruppen 10, 11 verschalten sind.
Die Elektrodengruppe 10 wird durch die zwei oberen Elektroden 17 und 18 und eine untere Elektrode 19 bzw. Rückseitenelektrode gebildet. Die Elektrodengruppe 11 umfaßt die gegenüberliegenden oberen Elektroden 20 und 21 sowie ebenfalls die untere oder Rückseitenelektrode 19. Die Elektroden 17, 21 sowie 18, 20 sind symmetrisch bezüglich der Längsachse des plattenförmigen piezoelektrischen Wandlers 9 ausgeführt. Weiterhin sind die Elektroden 17 und 18 sowie 20 und 21 gemäß Fig. 2 paarweise diagonal elektrisch verschalten. Die zwischen den Vorder- und Rückseitenelektroden liegende Piezokeramik ist homogen und senkrecht zu den Elektrodenoberflächen nach Fig. 2 polarisiert.

Die Länge und die Breite des piezoelektrischen Wandlers 9 sind beim Ausführungsbeispiel so ausgewählt, daß ihr Verhältnis zueinander circa 3,7 beträgt. Dies bedeutet, daß der piezoelektrische Wandler 9 auf die zweite Biege- und die erste Längsschwingungsmode abgestimmt ist.
Die Resonanzfrequenzen dieser Schwingungsmoden liegen nahe beieinander. Bei einer solchen Lage von Resonanzfrequenzen hat die Verteilung von Schwingungsgeschwindigkeiten für die Biegeschwingungen Vy und für die Longitudinalschwingungen Vx einen Verlauf entlang der Mittellinie gemäß den Darstellungen 22 und 23 bei Fig. 2.

Über die Länge L des plattenförmigen Piezowandlers existieren drei Knoten der Schwingungsgeschwindigkeit der Biegemode der Schwingungen, in denenen die Querkomponente der Schwingungsgeschwindigkeit Vy gleich null ist. Der Mittelknoten befindet sich auf der Linie A in der Mitte des plattenförmigen Wandlers 9, wobei zwei Außenknoten auf den Linien B und C verlaufen.

An den Stellen 24 der Längsschmalseiten des plattenförmigen piezoelektrischen Wandlers 9, die gleichzeitig den Außenknoten entsprechen, sind die elastischen Doppelrahmen 13, d.h. der Innenrahmenteil befestigt. Diese Stellen befinden sich auf den Linien B und C und sind um den Betrag d von den äußeren Stirnoberflächen des Piezowandlers 9 entfernt. Die Strecke d entspricht in etwa 1/9 bis 1/11 L, wobei der genaue Wert experimentell bestimmbar ist.

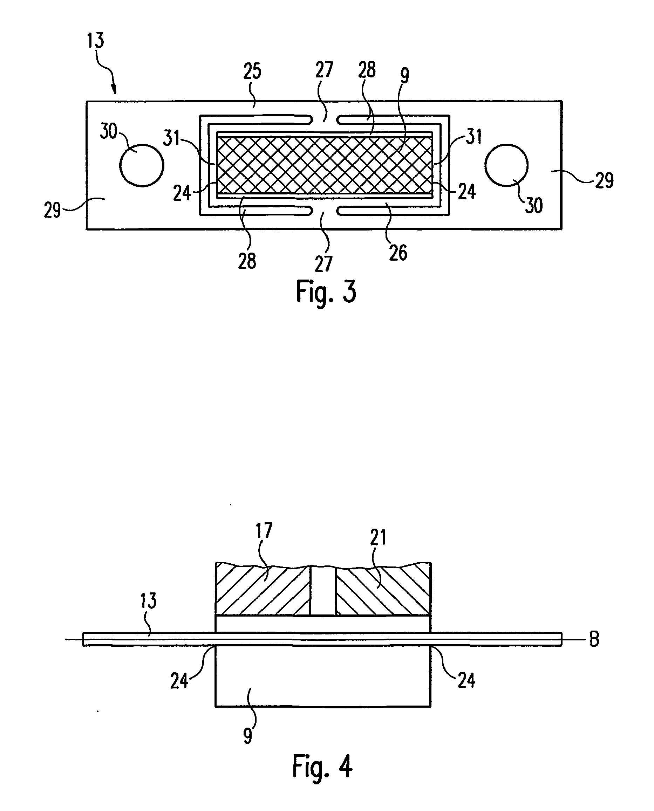

Einzelheiten des Aufbaus der flachen elastischen Doppelrahmen 13 sind den Fig. 3 und 4 zu entnehmen. Jeder Doppelrahmen 13 besteht aus einem Außenrahmen 25 und einem Innenrahmen 26. Außen- und Innenrahmen sind über einen Spalt getrennt und gegeneinander schwingend beweglich. Der Außenrahmen 25 ist mittels zwei zentral angeordneter Brücken oder Stege 27 mit dem Innenrahmen 26 verbunden. Zwischen den beiden Rahmen 25 und 26 und zwischen dem Innenrahmen 26 und den größeren der Seitenoberflächen des plattenförmigen piezoelektrischen Wandlers 9 existieren die bereits erwähnten Spalte 28. Der Außenrahmen 25 hat an beiden seiner seitlichen Flächen 29 Bohrungen oder dergleichen Ausnehmungen 30, die der Befestigung des Rahmens 13 am Gehäuse 6, z.B. mit Hilfe der Schrauben 14 (Fig. 1) dienen.

Die flachen, elastischen Doppelrahmen 13 werden bevorzugt aus wärmebehandelten 0,1 bis 0,5 mm starker Berylliumbronze oder einem entsprechenden Stahlband mittels Laserschneidens oder chemischen Ätzens gefertigt. Im gleichen technologischen Herstellungszyklus werden die zwischen den Rahmen liegenden Spalte realisiert. Die Spaltstärke liegt im Bereich zwischen 0,1 bis 0,2 mm. Die zwischen Innenrahmen 26 und den größeren Seiten des plattenförmigen Wandlers 9 befindlichen Spalte 28 können im Bereich zwischen 0,05 bis 0,1 mm gewählt werden.

Der Innenrahmen 26 ist mit seinen seitlichen Teilen 31 starr, insbesondere stoffschlüssig an den jeweiligen Längsschmalseiten, d.h. den kleineren Seitenflächen des plattenförmigen Wandlers 9 befestigt. Die betreffenden Stellen sind mit dem Bezugszeichen 24 nach Fig. 4 gekennzeichnet.

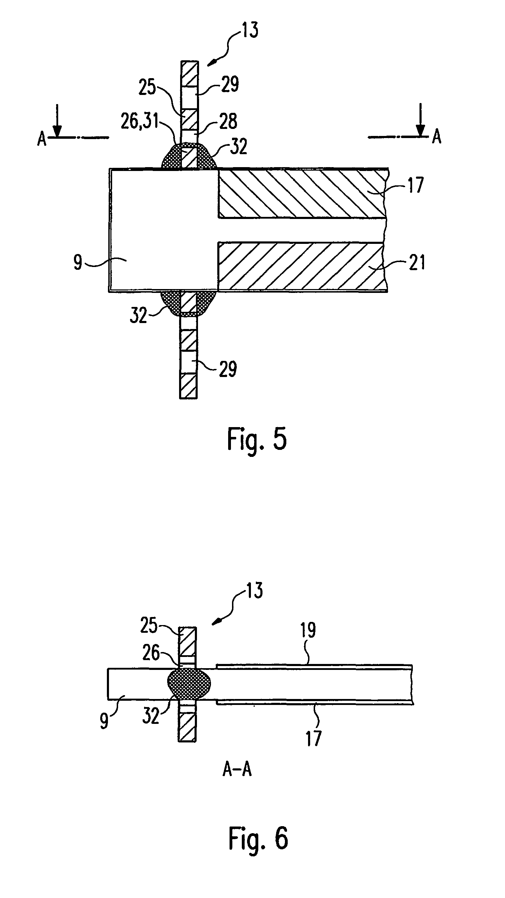

Die starre Befestigung der Innenrahmenseiten 26 an den kleineren Seitenflächen des plattenförmigen Piezowandlers 9 kann mittels Klebeverbindung durchgeführt werden, indem ein Epoxidharztropfen 32 (siehe Fig. 5 und 6) unmittelbar auf die Piezokeramikoberfläche aufgebracht wird.

Alternativ besteht die Möglichkeit, eine Lötverbindung auszubilden, wobei hier die Seiten des Rahmens 26 mit den zuvor auf die Piezokeramik aufgebrachten Metallzwischenschichten unter Verwendung eines weichen Lötmittels verlötet werden. Die Metallzwischenschicht kann auf die Oberfläche des Piezowandlers 9 an den entsprechenden Stellen 24 durch Vakuumbeschichtung aufgebracht werden. Denkbar sind Mehrschichtstrukturen nach der Art Chrom-Kupfer-Nickel, Titan-Kupfer-Nickel oder dergleichen, die eine gute Lötbarkeit und eine optimierte Verbindung mit der Oberfläche der Piezokeramik besitzen.

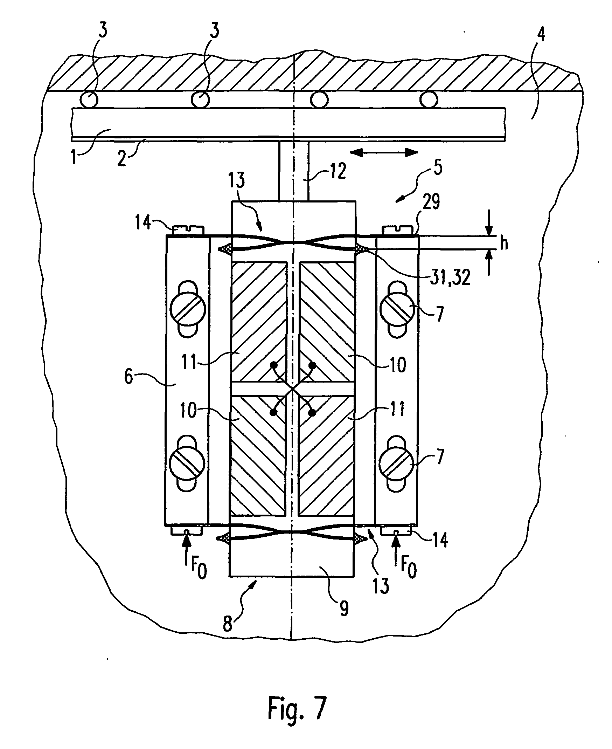

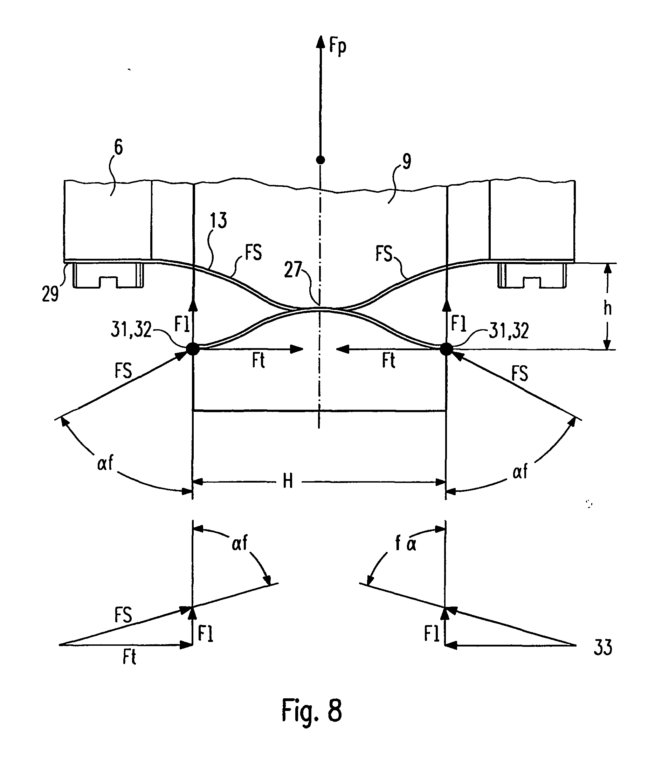

Die Fig. 7 zeigt eine Draufsicht eines einsatzbereiten piezoelektrischen Linearantriebs mit einer vergrößerten Darstellung der quasi x-förmigen Deformation der Doppelrahmen 13, wobei hier die seiten der Innen- und Außenrahmen 29, 31 auf ein Maß h durchgebogen werden. Gemäß Fig. 8 sollen die in bzw. an den Doppelrahmen 13 wirkenden oder dort entstehenden Kräfte näher erläutert werden.

Beim Zusammenbau des piezoelektrischen Antriebs werden zwei längs der X-Achse wirkende und senkrecht zur Friktionsoberfläche 2 des Läufers 1 stehende Hilfskräfte F0 (siehe Fig. 7) erzeugt. Hierbei stützt sich das Friktionselement 12 auf die Friktionsoberfläche 2 ab und die Doppelrahmen 13 ziehen sich auf die Abstände h auseinander. Die Abstände h werden durch die Elastizität der Doppelrahmen 13 und die resultierende Kraft 2F0 bestimmt. Die Kraft 2F0 wird gleich der Kraft Fp eingestellt, die das Friktionselement 12 an die Friktionsoberfläche 2 preßt. Danach wird das Gehäuse 6 mit Hilfe der Schrauben 7 an der Unterlage oder dem Träger 4 befestigt.
Dies führt dazu, daß in den elastischen Doppelrahmen 13 zwei Elastizitätskräfte FS entstehen, die unter dem Winkel αf zu den kleineren Seitenflächen des plattenförmigen Piezowandlers 9 wirken, wie dies der Fig. 8 entnommen werden kann.

Nach dem Befestigen des Gehäuses 6 werden die Hilfskräfte F0 aufgehoben.

Als Angriffspunkt der Elastizitätskräfte FS dienen die Stellen 24, an denen die Doppelrahmen 13 an den kleineren Seitenflächen des plattenförmigen Piezowandlers 9 befestigt sind. Jede der Elastizitätskräfte FS wird an den Stellen 24 in zwei Komponenten zerlegt. Eine Komponente ist längs der Seitenfläche gerichtet und wird mit Fl bezeichnet. Die zweite Komponente ist senkrecht hierzu orientiert und wird mit Ft bezeichnet. Die Kräfte FS, Fl und Ft bilden das mit der Darstellung 33 deutlich gemachte Kräftedreieck.

Die Kräfte Fl sind in die Richtung der Friktionsoberfläche 2 des Läufers 1 gerichtet. Diese pressen das Friktionselement 12 an die Friktionsoberfläche 2, wobei die Anpreßkraft Fp durch die Summe der vier Kräfte Fl gebildet ist.

Zusätzlich sind die Kräfte Fl bestrebt, den Wandler 9 bezüglich der Seitenfläche 29 der Doppelrahmen zu verschieben. Die Kräfte Ft sind gegeneinander orientiert und drücken den plattenförmigen Piezowandler 9 zusammen, so daß sie den Kräften Fl entgegenwirken und den Wandler fixieren.

Die Kraft Ft beträgt bezüglich der Kraft Fl ca. Ft=(Fl x H)/h. Bei den beispielsweise gegebenen Abmessungen des plattenförmigen Piezowandlers von 37 x 10 x 3 mm und des Friktionselements 3 x 3 x 4 mm beträgt die statische Anpreßkraft Fp ca. 10 N. Bei der Stärke der Doppelrahmen von 0,3 mm und deren Abmessungen von 22 x 6 mm entsteht die Kraft von 10 N bei dem Auseinanderziehen der Doppelrahmen 13 auf den Abstand von ca. h = 0,5 mm. Dies bedeutet, daß bei der Anpreßkraft Fp von 10 N die beiden Elastizitätskräfte FS ausgehend vom Mittelrahmen 13 eine Druckkraft Ft = 12,5 N bilden.

Für eine Seite an dem Doppelrahmen 13 beträgt das Verhältnis Ft/Fl = 3,125. Dies bedeutet, daß mit der vorgeschlagenen Vorrichtung und Halterung zur Querbefestigung und zum Anpressen des Erregers unter dem Einfluß der statischen Anpreßkraft Fp eine statische zusammendrückende Kraft Ft resultiert, die senkrecht zu den Seitenflächen plattenförmigen Piezowandlers 9 gerichtet sind, und die wesentlich größer als die Verschiebungskraft Fl ist. Eine solche quasi Kräfteumwandlung dient einer guten und sicheren Verbindung der Federanordnung der Doppelrahmen mit dem Piezowandler 9, ohne daß es zur Ausbildung von stark belasteten und damit Sollbruchstellen kommt.

Zusammenfassend zeigt Fig. 8 die Kräftewirkungen, die im Doppelrahmen 13 der Halterung entstehen. Die Kräfte FS sind die Elastizitätskräfte der flachen Doppelrahmen 13, wobei diese längs der Rahmen 13 wirken und unter dem Winkel αf an die Längsschmalseiten des plattenförmigen Piezowandlers 9 angreifen. Jede der Kräfte Ft wird in zwei Kräfte zerlegt, nämlich in die Kraft Fl, die senkrecht zur Friktionsoberfläche 2 des Läufers 1 gerichtet ist, und die Kraft Ft, die senkrecht zu den Längsschmalseiten des Piezowandlers 9 gerichtet ist. Die Summe der Kräfte Fl bildet die Anpreßkraft Fp, die das Friktionselement 12 an die Friktionsoberfläche 2 drückt. Die Kräftepaare Ft pressen den Wandler 9 zusammen und fixieren diesen.

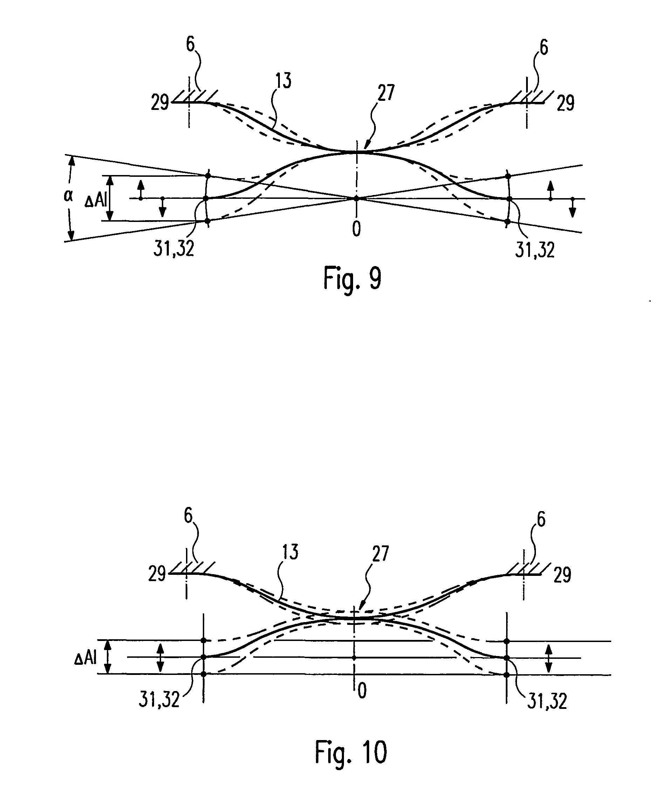

Ergänzend sei bezüglich der Fig. 9 und 10 auf verschiedene Schwingungsformen aufmerksam gemacht, wobei die Schwingungen nach Fig. 9 auf den Einfluß der Biegemode und die Schwingungen nach Fig. 10 auf diejenigen der Longitudinalmode des Erregers zurückzuführen sind.

Bei der voranstehenden Schilderung des Ausführungsbeispiels wurde bereits das Friktionselement für den piezoelektrischen Antrieb zum Übertragen von Kräften zwischen Ständer und Läufer erwähnt. Dieses Friktionselement weist hier eine Doppelschichtstruktur auf, wobei deren mit dem Wandler verbundene Teil der Schichtstruktur als harter, poröser Körper und der mit dem Läufer in Kontakt stehende Teil der Schichtstruktur als abriebfester, monolithischer Körper ausgeführt und wobei beide Schichten durch Sintern fest miteinander verbunden sind. In den Poren des mit dem Wandler verbundenen Teils der Schichtstruktur sind Füllstoffe zum Erhalt einer festen Verbindung zwischen der Wandleroberfläche einerseits und dem Friktionselement andererseits befindlich bzw. eingebracht. Diese Füllstoffe sind beispielsweise Epoxidharz und/oder niedrigschmelzende Gläser.

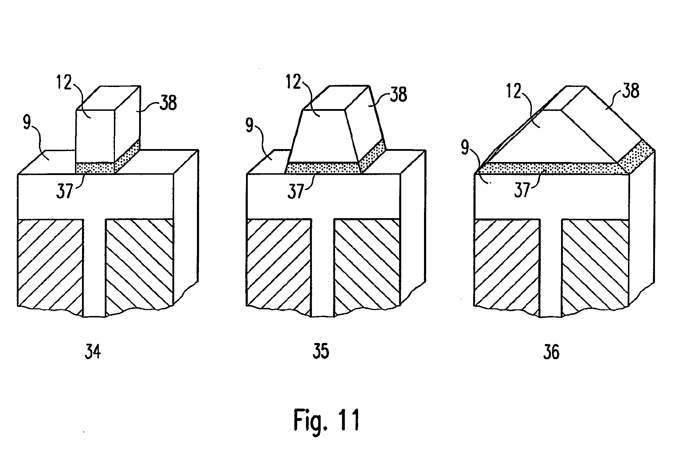

Ausführungsvarianten des Friktionselements mit Doppelschichtstruktur sind der Fig. 11 zu entnehmen. Darstellung 34 zeigt einen rechteckförmigen, Darstellung 35 ein trapez- oder pyramidenstumpfförmiges und Darstellung 36 ein konisches Friktionselement 12.

Die gezeigten Friktionselemente 12 besitzen die erwähnte Doppelschichtstruktur, die hier parallel zur Stirnoberfläche des piezoelektrischen Wandlers 9 angeordnet ist. Die Schicht 37, welche mit der Oberfläche des piezoelektrischen Wandlers 9 verbunden ist, wird als der erwähnte harte, aber poröse Körper ausgeführt, wobei die Schicht 38, die mit der Friktionsoberfläche 4 des Läufers 1 in Kontakt kommt, aus einem harten, abriebfesten monolithischen Material besteht. Als Material für den Läufer können Aluminiumoxid, Zirkonoxid oder ähnliche Werkstoffe Verwendung finden.

Bei der Schaltungsanordnung gemäß Ausführungsbeispiel zum Betreiben eines piezoelektrischen Antriebs, insbesondere eines piezoelektrischen Motors, wobei der Antrieb als piezoelektrischer Erreger aus einem monolithischen, plattenförmigen, im wesentlichen rechteckigen, Elektrodenflächen aufweisen piezoelektrischen Wandler ausgeführt ist und die Elektrodenflächen sich auf der Vorder- und Rückseite der Längsseiten des Wandlers befinden, wird ein Grund- oder Steuergenerator verwendet, der unmittelbar mit einem ersten Eingang eines zweikanaligen Brückenleistungsverstärkers und über einen Phasenschieber mittelbar mit dem zweiten Eingang des Leistungsverstärkers verbunden ist. Die Ausgänge des Brückenleistungsverstärkers werden über ein Filter auf die Primärseite eines summierenden Transformators geführt, wobei die Sekundärseite des Transformators einerseits an die Rückelektrode und andererseits über eine Umschalter wahlweise an eines der Paare der Vorderseitenelektroden angeschlossen ist. Das verwendete Filter ist eine in Serie geschaltete L-C-Anordnung.

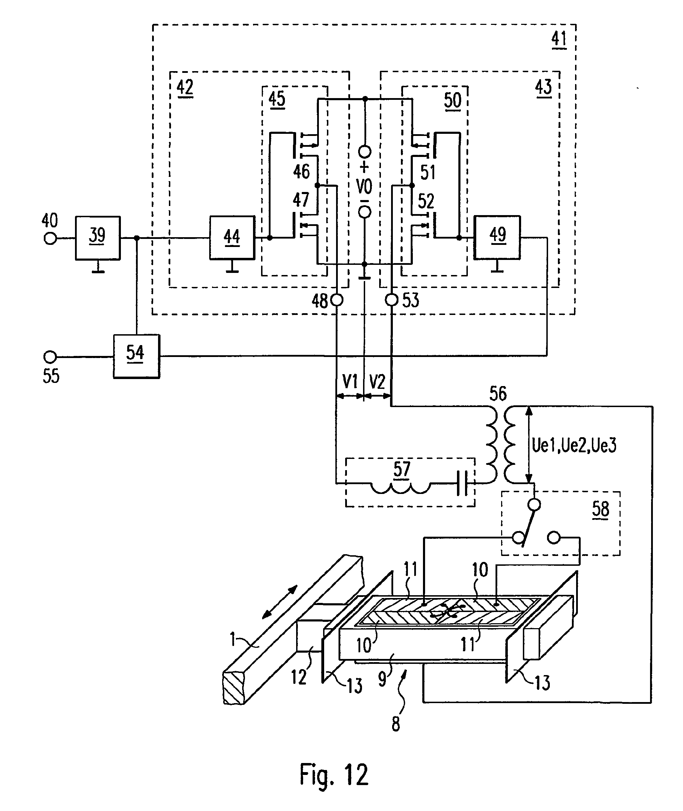

Mit Hilfe der Fig. 12 soll eine erste Ausführungsvariante der Schaltungsanordnung beschrieben werden. Die Schaltungsanordnung, die in Fig. 1 mit 15 bezeichnet ist, umfaßt einen Grund- oder Steuergenerator 39 mit einem frequenzsteuernden Eingang 40, einem Brückenleistungsverstärker 41 mit einem ersten 42 und einem zweiten 43 Kanal und mit einer Spannungsquelle V0 (nicht dargestellt).

Der erste Kanal 42 besteht aus einem Treiberbaustein 44 und der einen Hälfte des Leistungsverstärkers 45 mit den Schaltertransistoren (FET) 51, 52 und den Ausgangsknoten 53.

Der Eingang des ersten Kanals 42 des Leistungsverstärkers ist direkt am Ausgang des Grundgenerators 39 und der Eingang des zweiten Kanals 43 über den Phasenschieber 54 an den Ausgang des Grund- oder Steuergenerators 39 angeschlossen. Der Phasenschieber 54 besitzt darüber hinaus einen Steuereingang 55.

In die Diagonale des Brückenleistungsverstärkers 41, d.h. an die Ausgänge 48 und 53 ist der erwähnte Summierer des Transformators 56 und ein L-C-Serienglied als Filter 57 eingeschleift.
Die Sekundärwicklung des Transformators 56 wird über den Umschalter 58 mit jeweils einer der Elektrodengruppen 10, 11 des piezoelektrischen Wandlers 9 verbunden.

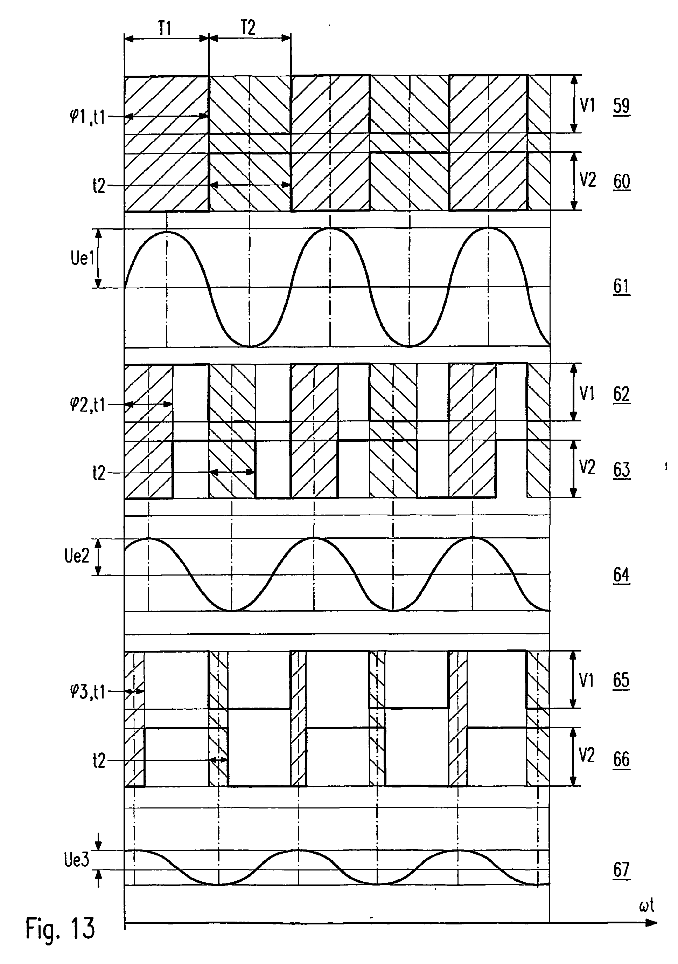

Fig. 13 zeigt erläuternde Spannungsverlaufsdiagramme zum Verständnis des Motorbetriebs.
Die in den Diagrammen 59, 62 und 65 erkennbaren Spannungsverläufe V1 treten am Ausgang 48 des Brückenleistungsverstärkers 45 auf. Die Verläufe gemäß den Diagrammen 60, 63 und 66 zeigen die Spannungen V2 am Ausgang 53 des Brückenleistungsverstärkers 50. Die Darstellungen nach 61, 64 und 67 betreffen die Spannungen Ue1, Ue2, Ue3 bei unterschiedlichen Phasenverschiebungen ϕ1, ϕ2 und ϕ3 zwischen den Spannungen V1 und V2. Die Zeiten t1 und t2 entsprechen den Anschlußzeiten der Spannungsquelle V0 an die Primärwicklung des summierenden Transformators 56 für die erste T1- und die zweite T2-Periodenhälfte.

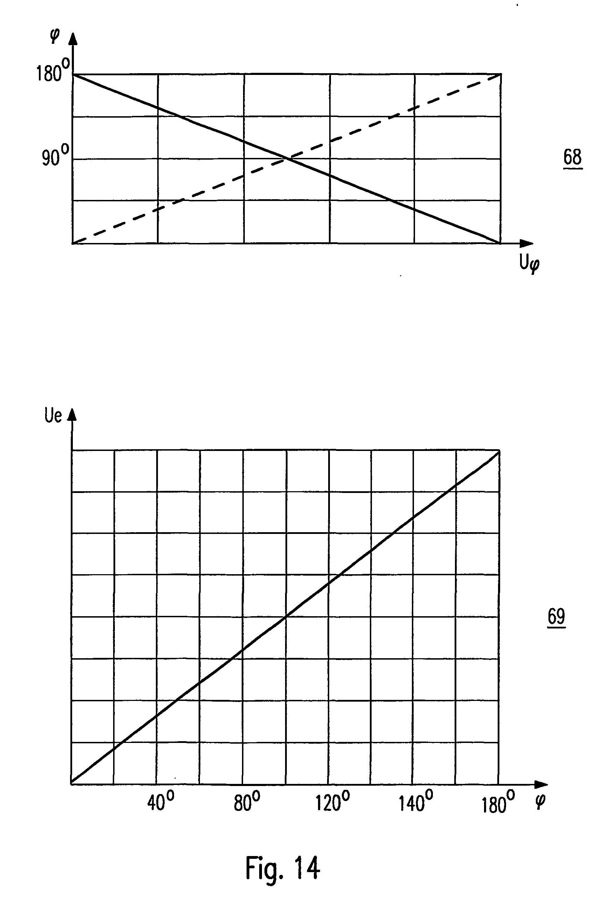

Fig. 14 dient der Erläuterung der Arbeitsweise des mit der Fig. 12 erläuterten schaltungsanordnungsgemäßen Teils zum Antrieb des Motors. Das Diagramm 68 zeigt hierbei die Abhängigkeit des Phasenverschiebungswinkels ϕ des Phasenschiebers 54 zwischen seinen Eingangs- und Ausgangssignalen bezüglich der Spannung UV am Steuereingang 55. Das Diagramm 69 läßt die Abhängigkeit des Phasenverschiebungswinkels ϕ und der Spannung Ue an der Sekundärwicklung des summierenden Transformators 56 erkennen.

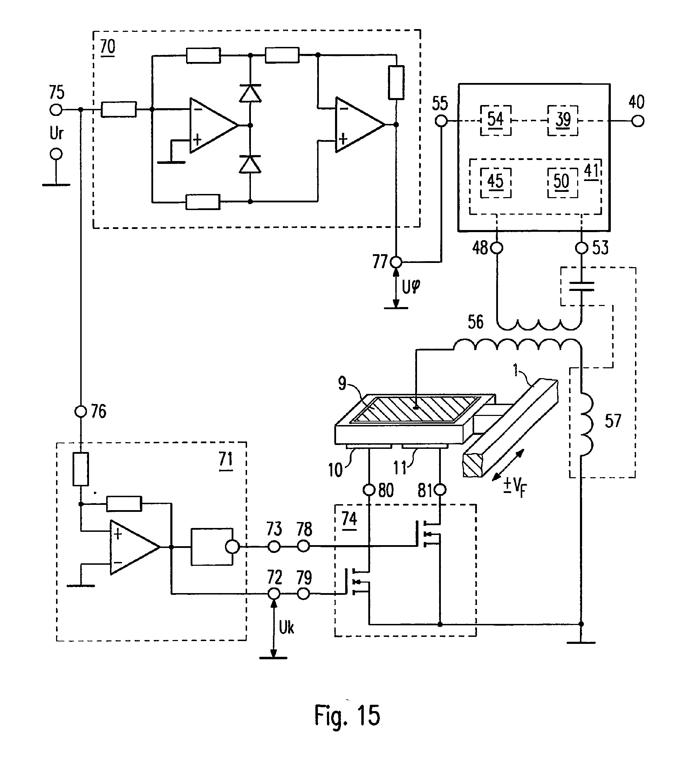

Bei der weiteren schaltungstechnischen Ausführungsform zum Betreiben eines piezoelektrischen Antriebs gemäß Fig. 15 ist zusätzlich ein Signalpegelwandler 70, ein Komparator 71 mit nichtinvertierendem 72 und invertierendem Eingang 73 und ein elektronischer Elektrodengruppenkommutator 74 vorgesehen.

Der Eingang 75 des Signalpegelwandlers 70 ist mit dem Komparatoreingang 76 verbunden. Der Ausgang 77 des Signalpegelwandlers 70 ist an den Eingang 55 des Phasenschiebers 54 angeschlossen. Die Komparatorausgänge 72, 73 sind mit den Eingängen 78, 79 des Elektrodengruppenkommutators verbunden, wobei dessen kommutierende Anschlüsse 80, 81 zu den zwei Elektrodengruppen 10, 11 führen.

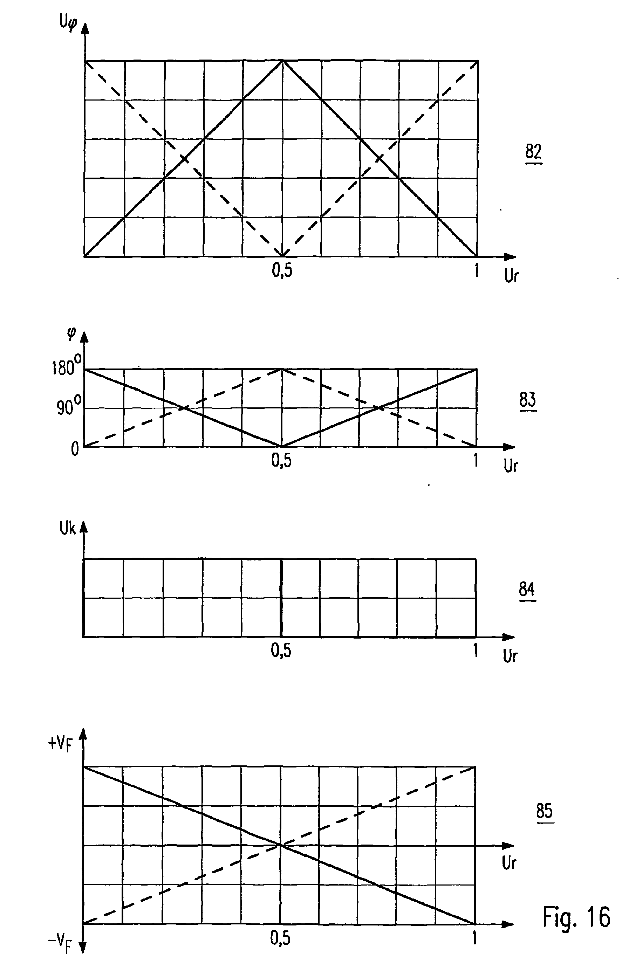

Wie der Fig. 16 und den dort gezeigten Diagrammen entnommen werden kann, ergibt sich gemäß Diagramm 82 eine spezielle Abhängigkeit der an dem Ausgang 77 des Signalpegelwandlers 70 liegenden Spannung Uϕ von der am Ausgang 75 anliegenden Spannung Ur. Das Diagramm 83 zeigt die Abhängigkeit des Phasenverschiebungswinkel ϕ am Eingang und Ausgang des Phasenschiebers 54 bezüglich der Spannung Ur. Diagramm 84 offenbart die Abhängigkeit der Spannung Uk an dem nichtinvertierenden Komparatoreingang 72 von der Spannung Ur. Die Abhängigkeit der Bewegungsgeschwindigkeit des Läufers 1 von der Spannung Ur ist mit dem Diagramm 85 deutlich gemacht.

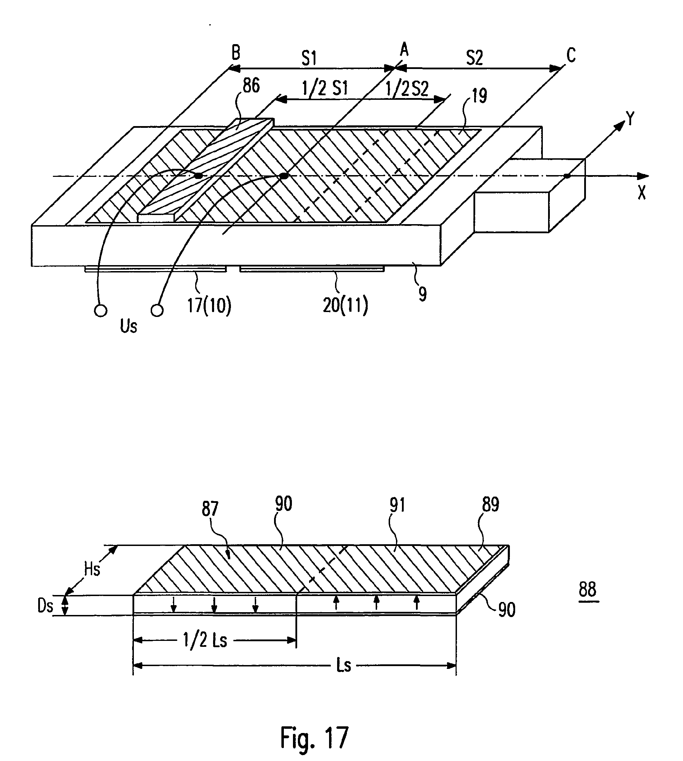

Gemäß der Darstellung nach Fig. 17 besteht die Möglichkeit, auf den plattenförmigen piezoelektrischen Wandler 9 einen Biegesensor 86 anzuordnen, welcher mechanische Biegeschwingungen des Erregers 8 feststellt.
Der Sensor 86 ist als dünne piezoelektrische Platte mit der Länge Ls, der Höhe Hs und der Stärke Ds als Platte 87 ausgebildet. Die Darstellung 88 zeigt den Sensor in Seitenansicht,

Auf den zwei Hauptseiten der piezoelektrischen Platte des Sensors sind Elektroden 89 und 90 angeordnet. Die Platte 87 hat zwei der Länge nach gleiche Teile 90 und 91, in denen die Piezokeramik in zwei entgegengesetzten Richtungen, senkrecht zu den Elektroden 88 und 89, polarisiert ist. Die Polarisation ist mit den Pfeildarstellungen symbolisch gezeigt.

Die Plattenabmessungen 87 des Sensors 86 werden durch die Abmessungen des plattenförmigen piezoelektrischen Wandlers 9 des eigentlichen Erregers bestimmt. Die Plattenlänge Ls soll gleich der Breite des Wandlers sein, wobei die Breite Hs im Bereich zwischen 0,02 bis 0,2 der Länge L liegt. Die Stärke Ds soll unter Beachtung technologischer Möglichkeiten minimiert werden. Typischerweise liegt die Stärke Ds im Bereich zwischen 0,1 bis 0,3 mm.

Die Platte 87 des Sensors 86 wird auf der Oberfläche des plattenförmigen piezoelektrischen Wandlers 9 mit diesem verbunden, und zwar auf der unteren Elektrode (Rückseitenelektrode) 19 und dort in der Mitte zwischen dem mittleren Knoten der Biegemode der Schwingungen und einem der Seitenknoten, d.h. in der Mitte zwischen den Linien A und B oder A und C, senkrecht zu den Längsschmalseiten des Piezowandlers verlaufend.
Die Befestigung des Sensors 86 auf der Wandleroberfläche 9 kann durch Kleben unter Verwendung von Epoxidharz oder durch Löten mit Hilfe eines Weichlots erfolgen.

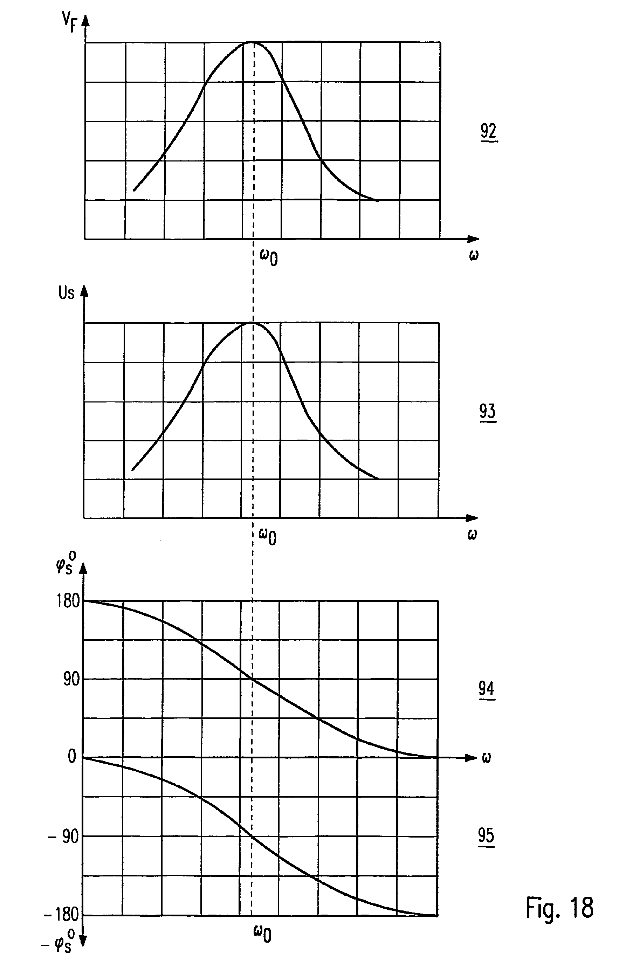

Bezüglich der Funktionsweise des Biegesensors 86 mit Blick auf die zu detektierenden mechanischen Biegespannungen sei auf die Fig. 18 verwiesen. Die Darstellung 92 zeigt die Abhängigkeit der Bewegungsgeschwindigkeit Vf des Läufers 1 von der Kreisfrequenz ω des Grundgenerators 39. Die Kreisfrequenz ω0 entspricht der Höchstgeschwindigkeit des Läufers 1. Mit Hilfe der Darstellung 93 wird die Abhängigkeit der an den Elektroden 89, 90 des Sensors 87 liegenden Spannung Us von der Kreisfrequenz ω des Grundgenerators 39 gezeigt, wobei die Darstellungen 94 und 95 Frequenzabhängigkeiten der Phasenverschiebung der Spannung Us und der Spannung Ue an einer der Elektrodengruppen symbolisieren.

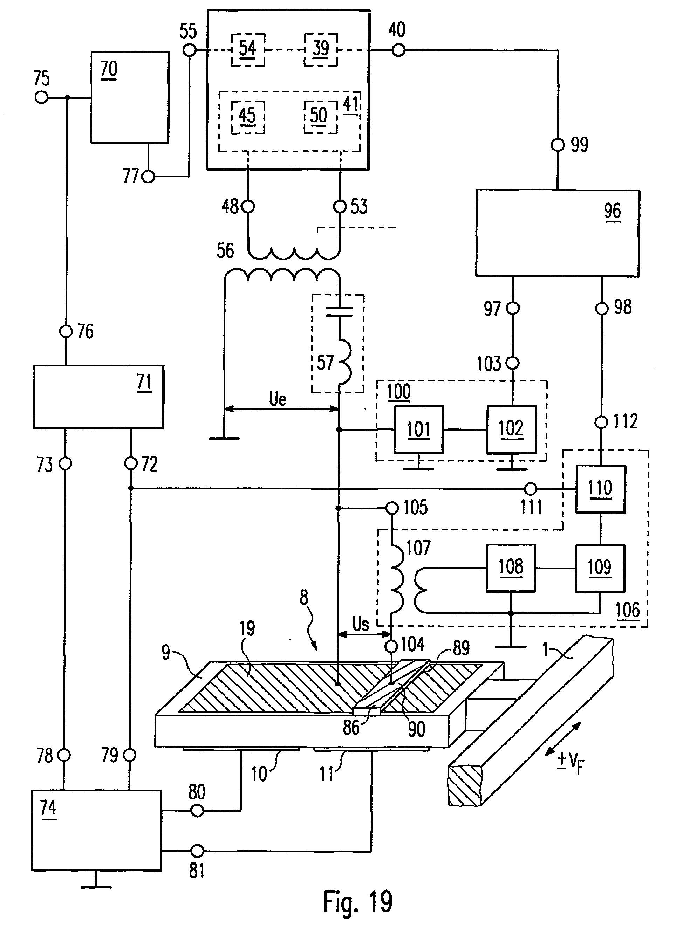

Die Ausgangssignale des Biegesensors 86 werden, wie in der Fig. 19 prinzipiell gezeigt, in die Schaltungsanordnung zur Steuerung und zum Betreiben eines piezoelektrischen Antriebs eingebunden. Zusätzlich ist hier der Phasendetektor 96 mit Phasenstützeingang 97, Phasensteuerungseingang 98 und Steuersignalausgang 99 vorgesehen.

Die Elektrode 90 einer der Elektrodengruppen 10 oder 11 ist am Stützsignalerzeuger 100 angeschlossen, welcher einen Signalbegrenzer 101 sowie einen Komparator 102 umfaßt. Der Ausgang 103 des Stützsignalerzeugers 100 ist mit dem Eingang 97 des Phasendetektors 96 verbunden. Die Elektroden 90, 89 des Biegesensors 86 sind an die Eingänge 104, 105 des Steuersignalerzeugers 106 gelegt. Der Steuersignalerzeuger umfaßt weiterhin einen Trenntransformator 107, ein Filter 108, einen Komparator 109 und einen Steuerinverter 110 mit Steuereingang 111. Der Ausgang 112 des Steuersignalerzeugers 106 ist mit dem Steuersignaleingang 98 des Phasendetektors 96 verbunden.

Die Funktionsweise vorstehend beschriebener Schaltungen ergibt sich wie folgt. Mit Inbetriebnahme wird eine Spannung erzeugt, deren Frequenz ω gleich der Resonanzfrequenz des mechanischen Resonators in der zweiten Mode der Biegeschwingungen des Erregers 8 ist. Diese Spannung wird über die Anschlüsse 16 an eine der Elektrodengruppen 10 oder 11 des plattenförmigen piezoelektrischen Wandlers 9 geführt. Die Elektrodengruppe 10 wird durch die zwei elektrisch miteinander verbundenen oberen Elektroden 17, 18 und die untere Elektrode 19 (siehe Fig. 2) gebildet.

Die Elektrodengruppe 11 resultiert aus den zwei elektrisch miteinander verbundenen oberen Elektroden 20 und 21 sowie der unteren Elektrode 19. Die elektrische Spannung der Schaltungsanordnung 15 wird entweder an die Elektroden 17, 18 und 19 oder an die Elektroden 20, 21 und 19 geführt.

Die Länge L und die Breite H des plattenförmigen piezoelektrischen Wandlers 9 sind so gewählt, daß die mechanischen Resonanzfrequenzen der zweiten Biege- und der ersten Longitudinalmode der Schwingungen des Erregers nahe beieinander liegen. Üblicherweise ist die Resonanzfrequenz der Longitudinalschwingungen um einen gegebenen Betrag größer als die Resonanzfrequenz der Biegeschwingungen, deshalb ist beim gezeigten Beispiel das Verhältnis L:H ungefähr 3:7 gewählt.

Dadurch, daß die Elektroden 17, 18 und 20, 21 bezüglich der Längsachse des plattenförmigen Erregers diagonal verbunden sind, ist die Wirkung der angelegten Spannung unsymmetrisch. Aufgrund dessen werden im Erreger gleichzeitig Biege- und Longitudinalschwingungen erzeugt. Da die Amplitude dieser Schwingungen mit Bezug auf die Größe des Erregers klein ist, können diese Schwingungen unabhängig voneinander betrachtet werden.

Gemäß Diagramm 22 nach Fig. 2 ergibt sich eine Verteilung von Querschwingungsgeschwindigkeiten Vy entlang der Oszillatorlänge L, die aufgrund der Biegedeformation des Erregers 8 entsteht. Diagramm 23 nach Fig. 2 offenbart die Verteilung von Längsschwingungsgeschwindigkeiten Vx, die aufgrund der Längsdeformationen des Erregers entstehen. Die gegenseitige Schwingungsüberlagerung führt dazu, daß das Friktionselement 12 des Erregers 8 elliptische Bewegungen in der x-y-Ebene ausübt. Diese elliptischen Bewegungen werden durch das an die Friktionsoberfläche des Läufers nachgiebig angepreßte Friktionselement 12 auf den Läufer übertragen und führen zur gewünschten Bewegung desselben.

An den kleineren seitenoberflächen des plattenförmigen Wandlers, d.h. den Längsschmalseiten, befinden sich drei Knoten der Schwingungsgeschwindigkeiten Vy, in denen die Schwingungsgeschwindigkeit Vy gleich null ist. Die betreffenden Schwingungsknoten sind an den Linien A, B und C (siehe Diagramm 23 nach Fig. 2) angeordnet. Mit anderen Worten befinden sich an jeder der Längsschmalseiten des plattenförmigen piezoelektrischen Wandlers drei Stellen, an denen keine Querkomponenten der Schwingungsgeschwindigkeit Vy existieren. Demnach sind die Stellen mit dem Bezugszeichen 24 in der Nähe der Linien B und C bevorzugt geeignet, um ein Befestigen des plattenförmigen piezoelektrischen Wandlers unter dem Gesichtspunkt der auftretenden statischen und dynamischen Belastungen des Läufers vorzunehmen.

Die spezielle Halterung mit Doppelrahmen, d.h. die Vorrichtung zur Querbefestigung und zum Anpressen ist so ausgelegt, daß sie in Querrichtung X absolut elastisch für die dynamischen Kräfte ist, die mit der Frequenz ω0 seitens des piezokeramischen Wandlers wirken.

Für die statische Kraft, die entlang der Längsachse X wirkt, funktioniert die Vorrichtung wie eine elastische Feder, die die zum Anpressen des Friktionselements 12 an die Friktionsoberfläche 2 des Läufers notwendige Kraft erzeugt. Entlang der Achse Y werden keine dynamischen Kräfte von der Seite des piezoelektrischen Wandlers mit der Frequenz ω0 erzeugt, da keine Komponente der Schwingungsgeschwindigkeit Vy existiert. Für die Kräfte, die in der Querrichtung entlang der Y-Achse wirken, ist demnach die Halterung starr.

Bezüglich des Aufbaus der Doppelrahmen sei auf die vorangehende Beschreibung unter Zuhilfenahme der Figuren 1 bis 6 verwiesen.

Im Funktionszustand des Motors greifen am Gehäuse 6 statische Hilfskräfte Fp an, die entlang der X-Achse und senkrecht zur Friktionsoberfläche 2 des Läufers 1 gerichtet sind, wie dies anhand der Fig. 7 dargestellt ist. Hierbei stützt sich das Friktionselement 12 an der Friktionsoberfläche 2 ab und die Doppelrahmen 13 werden in kleine, gleiche Entfernungen h auseinandergezogen, die durch die Elastizität der Doppelrahmen und die resultierende Kraft 2Fp bestimmt ist.

Die resultierende Kraft 2Fp ist so gewählt, daß sie gleich der statischen Anpreßkraft des Friktionselements 12 an die Friktionsoberfläche 2 des Läufers 1 ist. Hiernach wird das Gehäuse 6 mit Hilfe der Schrauben 7 an der Trägerunterlage 4 befestigt. Nachdem das Gehäuse derartig fixiert wurde, ergibt sich die Kraft 2Fp durch die Elastizität und die Federwirkung der Doppelrahmen 13, wobei die Hilfskräfte 2Fp aufgehoben werden können.

Bei beispielsweisen Abmessungen des plattenförmigen piezoelektrischen Wandlers von 37 x 10 x 3 mm und des Friktionselements von 3 x 3 x 4 mm ergibt sich eine statische Anpreßkraft 2Fp des Friktionselements 12 an die Friktionsoberfläche 2 in Höhe von 10 N. Bei einer Doppelrahmenstärke von 0,3 mm und Abmessungen des Doppelrahmens von im wesentlichen 22 x 6 mm ergibt sich die Kraft von 10 N beim Auseinanderziehen des Doppelrahmens auf einen Abstand h = 0,5 mm.

Wie aus dem Kräftedreieck der Darstellung 33 gemäß Fig. 8 entnommen werden kann, ergeben sich durch die spezielle Doppelrahmenanordnung und der Wirkung der statischen Anpreßkraft 2Fp zwei statische zusammendrückende Kräfte Ft, die senkrecht zu den kleineren Seitenoberflächen des plattenförmigen Piezowandlers wirken und welche wesentlich größer als die eigentliche Anpreßkraft 2Fp ist. Eine derartige Kräftezerlegung oder Kräfteumwandlung erhöht, wie dargelegt, die Verbindungszuverlässigkeit der Doppelrahmen-Federanordnung mit dem Piezowandler 9.

Zurückgehend auf die Fig. 9 und 10 wurden dort Schwingungsformen der Doppelrahmen 13 dargestellt, die sich unter der Biege- und Longitudinalmode der Schwingungen des Erregers einstellen. Die seitlichen Teile der Außenrahmen sind fest mit dem Gehäuse 6 verbunden und schwingen nicht. Die Biegemoden der Schwingungen verursachen ein Drehen der Seiten 31 des Innenrahmens 26 um den Punkt 0 um einen kleinen Winkel α. Hierbei haben die Schwingungen eine Amplitude ΔAb. Die Amplitude ΔAb ist klein und beträgt bei einer Piezolänge von L=37mm etwa 0,01 bis 0,5µm. Die Schwingungen der Doppelrahmen sind gemäß Fig. 9 durch eine Strichlinie repräsentiert. Die Innenrahmen 26 jeweils drehen sich um den Steg oder die jeweilige Brücke 27.

Die Longitudinalschwingungsmode führt zur Querverschiebung der Innenrahmenseiten 31, wobei die Schwingungsamplitude in diesem Fall ca. 3 bis 6µm (siehe Fig. 10) beträgt. Die Schwingungsform des Doppelrahmens 13 gemäß Fig. 10 ist ebenfalls durch eine Strichlinie deutlich gemacht. Der Innenrahmen 26 und ein Teil des Außenrahmens 25 bewegen sich beim Schwingen symmetrisch, und zwar hinsichtlich der befestigten Seiten 29 des Außenrahmens 25.

In beiden oben genannten Fällen verursachen die Schwingungen des Wandlers Biegebewegungen der Doppelrahmen.
Der Wandler und die mit ihm verbundenen Doppelrahmen wirken wir ein Schwingungssystem, wobei die Rahmen in das System eine niedrige reaktive Komponente und nahezu keine aktive Komponente einführen, da die Rahmen aus einem Werkstoff gefertigt sind, der eine hohe mechanische Güte besitzt. Beispielsweise beträgt die mechanische Güte von wärmebehandeltem Stahl oder Berylliumbronze mehr als 2000.

Demnach erfüllt die Halterung gemäß der Erfindung gleichzeitig zwei unterschiedliche Funktionen. So wird nämlich der Erreger in Querrichtung fixiert und es wird gleichzeitig das Friktionselement an die Friktionsoberfläche des Läufers gedrückt.

Dadurch, daß der vorbeschriebene piezoelektrische Motor sehr niedrige Innenverluste aufweist, können sehr hohe Translationsgeschwindigkeiten des Läufers erreicht werden, wobei hier Werte größer 1 bis 1,5 m/s denkbar sind.

Zur Übertragung der Reibungskräfte besitzt das erfindungsgemäße Friktionselement eine Doppelstruktur, um eine Verbindung zwischen Friktionselement und Piezokeramikoberfläche hoher Qualität zu gewährleisten und andererseits eine ausreichende Langzeitstabilität insbesondere gegen Abrieb an der Reibungsoberfläche zu erreichen.

Zur Verbindung des Friktionselements mit der erfindungsgemäßen Doppelstruktur hinsichtlich der Piezokeramikoberfläche wird ein Klebstoff verwendet, der eine optimale Verbindungsqualität mit der Keramik gewährleistet, wobei hier auf spezielle Epoxidharzsorten oder niedrigschmelzende Gläser verwiesen wird. Beim Kleben des zweischichtigen Friktionselements werden die Poren der porösen unteren Schichten mit einem Klebstoff aufgefüllt, so daß sich die gewünschte Verbindungssicherheit einstellt.

Schaltungsanordnungsseitig erzeugt der Grund- oder Steuergenerator 39 eine periodische elektrische Schwingung mit der Frequenz, die gleich der mechanischen Resonanzfrequenz der Biegemode ω0 ist. Diese Spannung wird einerseits direkt an den Eingang des ersten Kanals des Brückenleistungsverstärkers und andererseits an einen Phasenschieber gegeben. Der Ausgang des Phasenschiebers ist mit dem Eingang des zweiten Kanals des Brückenleistungsverstärkers verbunden. Beide Kanäle des Leistungsverstärkers besitzen Treiber, die eine rechteckige Spannung an die Steuerelektroden der Feldeffekttransistoren erzeugen, so daß an den Ausgängen der Halb-Brückenverstärker stets rechteckige symmetrische Spannungen V1, V2 vorhanden sind. Der Phasenschieber verschiebt die an seinem Eingang vom Grundgenerator 39 kommende Spannung um einen Winkel ϕ. Der Winkel ϕwird durch die an den Eingang des Phasenschiebers liegenden Steuerspannung Uϕ bestimmt. Bezüglich der Abhängigkeit zwischen der Phasenverschiebung und der Steuerspannung Uϕ sei nochmals auf Fig. 14, Darstellung 68 aufmerksam gemacht. Diese Abhängigkeit kann auch einen Verlauf gemäß Strichlinie besitzen.

Die am Steuereingang des Phasenschiebers anliegende Steuerspannung Uϕ verändert die Phasenverschiebung ϕ zwischen den Spannungen V1 und V2, die in den Zweigen des Brückenleistungsverstärkers anliegen. Ausgangsseitig ist am Brückenleistungsverstärker der summierende Transformator angeschlossen.

Bei Veränderung der Phasenverschiebung zwischen den Spannungen V1 und V2 ändert sich die Durchgangsleitzeit t1 und t2 durch die Schalttransistoren des Brückenleistungsverstärkers und den summierenden Transformator, der in beide Spannungsrichtungen V0 geschaltet ist. Während der Zeit t1 sind die Transistoren 46 und 52 und während der Zeit t2 die Transistoren 47 und 50 geöffnet. Die in der Diagonale des Brückenleistungsverstärkers 41 liegende und abgreifbare Spannung (Ausgänge 48 und 53) hat eine rechteckige Form und besitzt eine vom Winkel ϕ abhängige Dauer t1 und t2. Während der Zeiten (T1-t1 und T2-t2) sind die Ausgänge 48 und 53 des Brückenleistungsverstärkers verbunden, im ersteren Fall durch die Transistoren 47 und 52, im zweiten Fall durch die Transistoren 46 und 52.

Durch das in Reihe mit der Primärwicklung des summierenden Transformators geschaltete LC-Bandfilter 57 fließt durch den Transformator praktisch nur der Strom der ersten Harmonischen der an den Ausgängen 48 und 53 liegenden Spannung. Hierdurch hat die an der Sekundärwicklung des summierenden Transformators anliegende Spannung Ue einen sinusförmigen Verlauf. Die Amplitude dieser Spannung (Ue1, Ue2, Ue3) hängt von der Dauer t1 und t2 ab und ergibt sich auch in Abhängigkeit von der Phasenverschiebung ϕ (ϕ1, ϕ2, ϕ3) zwischen den Spannungen V1 und V2. Bezüglich dieser Abhängigkeit wird auf die Darstellung 69 gemäß Fig. 14 verwiesen.

Der Phasenverschiebungswinkel ϕ verändert sich durch die geänderte Steuerspannung Uϕ, die am Eingang 55 des Phasenschiebers 54 anliegt. Hierdurch ist die Spannung Ue an der Sekundärwicklung des summierenden Transformators auch von der Spannung Uϕ abhängig. Die Spannung Ue regt den piezoelektrischen Wandler an. Die Amplitude der Spannung Ue bestimmt hierbei die Schwingungsamplitude des Wandlers. Bei Änderungen der Spannung Uϕ ergibt sich auch eine Geschwindigkeitsänderung des Läufers 1.

Der mit der beschriebenen Schaltungsanordnung ansteuerbare piezoelektrische Motor ermöglicht also eine Geschwindigkeits steuerung des Läufers durch die Änderung der am Steuereingang des Phasenschiebers anliegende Steuerspannung Uϕ. Hierbei kann die Motorsteuerung quasi ohne Energieverlust realisiert werden, da die Ausgangstransistoren des Leistungsverstärkers 41 sich stets im Schaltbetriebmodus befinden.

Die Spannung Ue wird an die Elektrodengruppen 10 oder 11 angelegt, wobei eine Umschaltung mit Hilfe des entsprechenden Schalters 58 möglich ist. Durch Umschaltung kann die Bewegungsrichtung des Läufers geändert werden.

Wie anhand der Fig. 15 erläutert, besteht bei einer Ausführungsform der Steuerschaltung die Möglichkeit, Läufergeschwindigkeit und Richtung durch einpolige Steuerspannungen Ur vorzugeben. Hierfür ist zusätzlich der Signalpegelwandler, Komparator und der Elektrodengruppenkommutator vorgesehen.

Bei einer Steuerspannung von 0,5 Ur befindet sich der Läufer in einem abgebremsten Zustand, hingegen bei einer Spannung im Bereich 0 oder Ur selbst erfolgt eine Bewegung mit maximaler Geschwindigkeit. Die Abhängigkeit der Ausgangsspannung des Signalpegelwandlers von der Eingangsspannung Ur ist mit der Darstellung 28 gemäß Fig. 16 gezeigt. Bei der Erhöhung der Steuerspannung Ur erhöht sich auch die Ausgangsspannung Uϕ linear und erreicht bei der Spannung 0,5 Ur den maximalen Wert. Mit einer weiteren Erhöhung der Spannung Ur verringert sich die Spannung Uϕ linear. Da die Spannung Uϕ an den Steuereingang des Phasenschiebers gelangt, führt die Erhöhung der Ur zunächst zur Verkleinerung des Phasenverschiebungswinkels und danach zu einer Vergrößerung desselben, wie dies in der Darstellung 83 in Fig. 16 deutlich gemacht ist.

Zwischen dem Spannungswert 0,5 Ur und 0 befindet sich der Komparator in einem ersten Zustand. An seinem nichtinvertierenden Ausgang 72 steht dann der logische Wert 1 und am invertierenden Ausgang 73 der logische Wert 0 an. Bei einem solchen Zustand des Komparators 71 ist der Ausgang 80 des elektronischen Kommutators zusammengeschlossen und der Ausgang 81 geöffnet, wobei sich hier der Läufer mit der Geschwindigkeit Vf bewegt. Der Punkt 0,5 Ur ist der Umkehrpunkt der Bewegung des Läufers. Bei Durchgang durch diesen Punkt 0,5 Ur schaltet der Komparator 71 um, was zum Invertieren der Signale an den Ausgängen 72 und 73 und an den Eingängen 78 und 79 des Elektrodengruppenkommutators 74 führt. Letzteres führt zur Zustandsänderung des Kommutators 74. Sein Ausgang 80 wird nun geöffnet und der Ausgang 82 zusammengeschaltet. Hier ändert nun der Läufer seine Bewegungsrichtung. Eine weitere Verringerung der Spannung Ur verursacht die Erhöhung des Phasenverschiebungswinkels ϕ und eine Geschwindigkeitserhöhung Vf des Läufers.

Beim Betrieb von piezoelektrischen Motoren in einem breiten Temperaturbereich tritt eine Temperaturverschiebung der mechanischen Resonanzfrequenz ein. Dieser Effekt ist umso mehr ausgeprägt, je höher die Oszillatorgüte ist, d.h. je kleiner seine mechanischen Verluste sind. Die Temperaturverschiebung der Resonanzfrequenz behindert einen stabilen Motorbetrieb. Um diesen Effekt zu vermeiden, folgt die Erregerfrequenz des Grundgenerators in einer erläuterten Ausführungsform des Motors den Temperaturänderungen der Resonanzfrequenz der Biegeschwingungsmode des piezoelektrischen Erregers. Hier wird mit Hilfe eines Biegesensors die mechanische Biegekomponente der Spannungen bestimmt und ein entsprechendes Sensorsignal abgeleitet, das einem Rückkopplungszweig zugeführt wird.

Der flache plattenförmige Aufbau des Sensors mit einer Zweirichtungspolarisation ermöglicht das Selektieren einer Komponente einer elektrischen Spannung Us, die proportional zur Komponente des mechanischen Erregers ist, und die ihrerseits wiederum proportional zur Schwingungsgeschwindigkeit der Biegemode des Erregers steht.

Das Durchbiegen oder Verbiegen des plattenförmigen Wandlers in der Ebene XY längs der X-Achse führt zum Zusammenpressen einer Hälfte der Biegesensorplatte 87 und zum Auseinanderziehen der anderen Hälfte 90 bzw. 91 des Sensors 86. Bei einer solchen Sensorkonstruktion sind die von jeder Plattenhälfte 90 und 91 erzeugten Spannungen gleich groß und unipolar sowie proportional zu den mechanischen Erregerspannungen. Die Längsdeformation der Platte 87 als Folge der auf den Sensor 86 wirkenden Longitudinalschwindungsmode führt zum Zusammenpressen und Auseinanderziehen der Hälften 90 und 91, so daß gleiche, dem Vorzeichen nach aber unterschiedliche einander kompensierende Spannungen erzeugt werden.

Aus den Diagrammen 92 und 93 nach Fig. 18 ist die Abhängigkeit der Läufergeschwiindigkeit Vf und Spannungsamplitude Us an den Elektroden 89 und 90 des Sensors 86 von der Erregerfrequenz ω nachvollziehbar. Diese Abhängigkeiten bilden einander ab, wobei das Geschwindigkeitsmaximum Vf dem Spannungsmaximum Us entspricht. Beide Maxima befinden sich am Punkt der mechanischen Resonanzfrequenz der Biegeschwingungsmode ω0.

Die Diagramme 94 und 95 stellen Abhängigkeiten des Phasenverschiebungswinkels ϕf zwischen Erregerspannung Ue dar, die sich an einer Elektrodengruppe ergeben, und zeigen andererseits die Spannung Uf, die sich an den Elektroden 89 und 90 des Sensors 86 einstellt. Dem Maximalwert der Bewegungsgeschwindigkeit Vs entspricht der Phasenverschiebungwinkel ϕs = 90°. Beim Umschalten der Elektrodengruppen von Gruppe 10 auf Gruppe 11 verändert sich der Phasenverschiebungswinkel ϕs auf 180°, d.h. bis hin zu -90°. Die in der Darstellung 95 nach Fig. 18 gezeigte Abhängigkeit des Phasenverschiebungswinkels ϕs von der Erregerfrequenz ω erstreckt sich über einen breiten Temperaturbereich, wobei diese Abhängigkeit als Rückkopplungsvariante genutzt wird, um unter Berücksichtigung der Temperaturänderungen und der veränderten Resonanzfrequenz den Grundgenerator nachführen.

Der hierfür notwendige Rückkopplungszweig schließt den Sensor 86 und den Phasendetektor 96 ein. Der zusätzlich vorhandene Phasendetektor erzeugt ein Fehlersignal, das proportional der Phasenabweichung ϕf zwischen den Spannungen an seinem Stützeingang 97 und am Steuereingang 98 bezüglich eines Werts 90° oder einem anderen vorgegebenen Wert ist.
Das Fehlersignal wird vom Ausgang 99 an den Steuereingang 40 des Grundgenerators 39 weitergegeben, wodurch dessen Erregerfrequenz so verändert wird, daß die Phasendifferenz stets gleich einem vorgegebenen Wert ϕs bleibt.

Als Stützsignal wird die Spannung Ue an einer der Elektrodengruppen 10 oder 11 verwendet. Diese Spannung wird durch den Begrenzer 101 begrenzt und durch den Komparator 102 umgeformt. Das Steuersignal ist in diesem Fall die an den Sensorelektroden 89 und 90 anliegende Spannung Us. Die Spannung Us wird zunächst an den Trenntransformator 107 gegeben, wobei im Anschluß mittels eines Filters 108 die erste Harmonische herausgefiltert wird und über den Komparator 109 eine Umformung in ein Rechtecksignal erfolgt. Der Komparatorausgang 109 ist mit dem gesteuerten Inverter 110 verbunden, dessen Steuereingang mit einem der Komparatorausgänge 72 oder 73 in Verbindung steht.
Die Phase des Steuersignals wird durch den gesteuerten Inverter 110 in Abhängigkeit von der ausgewählten Elektrodengruppe 10 oder 11 um 180° gedreht. Im Anschluß wird das Signal vom Ausgang 112 des Inverters 110 an den Steuereingang 98 des Phasendetektors 96 weitergeleitet.

Mit der vorstehend beschriebenen Schaltung kann die Resonanzfrequenz des Grundgenerators gleich der mechanischen Resonanzfrequenz des Erregers über einen breiten Temperaturbereich gehalten werden, so daß der Motorbetrieb nahezu temperaturunabhängig mit hoher Präzision durchgeführt werden kann.

Der vorgestellte piezoelektrische Antrieb, insbesondere piezoelektrische Motor, besitzt niedrige mechanische Verluste durch die spezielle Halterung mittels Doppelrahmen. Die Verluste können durch die effektive Güte des unbelasteten Erregers abgeschätzt werden, d.h. im Betriebsfall ohne Kontakt mit dem Läufer. Die ermittelte Güte des unbelasteten Erregers liegt liegt zwischen 500 und 700. Demnach können in etwa zehnmal bessere typische Effektivwerte im Vergleich zu bekannten Motoren erreicht werden. Bei der vorgeschlagenen Lösung erwärmen sich die Verbindungsstellen des piezoelektrischen Wandlers mit der Halterung praktisch nicht, wodurch es keine zusätzliche Erregererwärmung gibt. Auch dies trägt zu einem verbesserten und stabilen Motorbetrieb bei. Der Motor besitzt daher eine günstigere Energiebilanz und einen höheren Wirkungsgrad. Die Erregerspannung kann bis zu dreimal kleiner sein als bei bekannten Lösungen. Ebenso ist die Präzision der Positionierung hoch und reicht bis in den Bereich einiger Nanometer hinein, was eine an sich theoretische Grenze darstellt.

### Bezugzeichen

- 1: Läufer
- 2: Friktionsoberfläche
- 3: Lager
- 4: Unterlage oder Träger
- 5: Antriebselement
- 6: Gehäuse des Antriebselements
- 7: Befestigungsschrauben des Gehäuses
- 8: Piezoerreger
- 9: plattenförmiger piezoelektrischer Wandler
- 10, 11: Elektrodengruppe
- 12: Friktionselement
- 13: flacher, elastischer Doppelrahmen
- 14: Befestigungsschrauben des Doppelrahmens
- 15: Treiberanordnung für den piezoelektrischen Wandler
- 16: Anschlußdrähte
- 17, 18: obere Elektrode
- 19: untere Elektrode
- 20, 21: obere Elektrode
- 22: Diagramme mit Darstellung der Schwingungsgeschwindigkeiten der Biegeschwingungsmode
- 23: Diagramme der Schwingungsgeschwindigkeiten der Longitudinalschwindungsmode
- 24: Befestigungstellen des flachen elastischen Doppelrahmens
- 25: Außenrahmen
- 26: Innenrahmen
- 27: Steg oder Brücke bzw. Mittelüberbrückung zwischen Innen- und Außenrahmen
- 28: Luftspalt
- 29: Seite des Außenrahmens
- 30: Befestigungsbohrungen im Außenrahmen
- 31: Seite des Innenrahmens
- 32: Kleber oder Lottropfen
- 33: Kräftedreieck
- 34 - 36: Ausführungsvarianten des Friktionselements
- 37: poröser Schichtteil
- 38: monolithischer Friktionsschichtteil
- 39: Grundgenerator
- 40: Steuereingang des Grundgenerators
- 41: zweikanaliger Brückenleistungsverstärker
- 42: erster Kanal des Brückenleistungsverstärkers
- 43: zweiter Kanal des Brückenleistungsverstärkers
- 44: Treiber des ersten Kanals
- 45: Halbbrücke des Leistungsverstärkers
- 46: oberer Transistor des Leistungsverstärkers
- 47: unterer Transistor des Leistungsverstärkers
- 48: Ausgang des Leistungsverstärkers
- 49: Treiber des zweiten Kanals des Leistungsverstärkers
- 50: Halbbrücke des Leistungsverstärkers
- 51: oberer Transistor des Leistungsverstärkers
- 52: unterer Transistor des Leistungsverstärkers
- 53: Ausgangs des Leistungsverstärkers
- 54: Phasenschieber
- 55: Steuereingang des Phasenschiebers
- 56: summierender Transformator
- 57: Filter
- 58: Elektrodengruppenumschalter
- 59 - 67: Spannungsdiagramme
- 68, 69: Erläuterungsdiagramme bezüglich der Arbeitsweise der Schaltungsanordnung
- 70: Signalpegelwandler
- 71: Komparator
- 72: nichtinvertierender Komparatorausgang
- 73: invertierender Komparatorausgang
- 74: elektrischer Elektrodengruppenkommutator
- 75: Steuereingang des Signalpegelwandlers
- 76: Komparatorausgang
- 77: Ausgang des Signalpegelwandlers
- 78, 79: Steuereingänge des elektronischen Kommutators
- 80, 81: Ausgänge des elektronischen Elektrodengruppenkommutators
- 82, 85: Erläuterungsdiagramme zur Wirkungsweise der Schaltungsanordnung
- 86: Biegesensor
- 87: piezoelektrische Sensorplatte des Biegesensors
- 88: Darstellung der piezoelektrischen Platte des Biegesensors
- 89, 90: Elektroden des Biegesensors
- 91: Abschnitt des Biegesensors
- 92 - 95: Erläuterungen zur Wirkung des Biegesensors
- 96: Phasendetektor
- 97: Stützsignaleingang des Phasendetektors
- 98: Steuereingang des Phasendetektors
- 99: Phasendetektoreingang
- 100: Stützsignalerzeuger
- 101: Signalbegrenzer
- 102: Komparator
- 103: Ausgang des Stützsignalerzeugers 100
- 104, 105: Eingänge des Steuersignalerzeugers
- 106: Steuersignalerzeuger
- 107: Trenntransformator
- 108: Filter
- 109: Komparator
- 110: gesteuerter Inverter
- 111: Steuereingang des Inverters
- 112: Ausgang des Inverters

## Patentansprüche

1. Piezoelektrischer Antrieb, insbesondere piezoelektrischer Motor zur Erzeugung kontinuierlicher oder schrittweiser Bewegungen, umfassend einen eine Friktionsoberfläche (2) aufweisenden Läufer (1), ein mit dieser Oberfläche in Kontakt bringbares Antriebselement (5) in Form eines piezoelektrischen Erregers (8), wobei der Erreger aus einem monolithischen, plattenförmigen, im wesentlichen rechteckigen, Elektrodenflächen (10.11) aufweisenden piezoelektrischen Wandler (9) besteht, eine äußere Befestigung (4,6), ein auf einer der Stirnseiten des piezoelektrischen Wandlers angeordnetes Friktionselement (12) sowie eine Halterung (13) für den piezoelektrischen Wandler und Mittel zum elastischen Anpressen des Friktionselements an die Friktionsoberfläche,
**dadurch gekennzeichnet, dass**
zur Halterung des piezoelektrischen Wandlers (9) sowie zum Erzeugen der Anpresskraft des Friktionselements (12) jeweils am äußeren Knoten der Biegeschwingungsmode ein elastischer, den Wandler umgreifender Doppelrahmen (13) mit Innen- (26) und Außenrahmen (25) angeordnet ist, wobei der Innenrahmen jeweils mit den Längsschmalseiten des Wandlers (9) und der Außenrahmen mit der äußeren Befestigung (6) verbunden ist, weiterhin der Außenrahmen und der Innenrahmen beabstandet sind und über Stege oder Brücken (27) in Kontakt stehen.

2. Piezoelektrischer Antrieb nach Anspruch 1,
**dadurch gekennzeichnet, dass**
der Doppelrahmen (13) einen längs seiner Achse symmetrischen Aufbau aufweist und die Stege oder Brücken (27) mittig angeordnet Innen- und Außenrahmen verbinden.

3. Piezoelektrischer Antrieb nach Anspruch 1 oder 2,
**dadurch gekennzeichnet, dass**
zwei gegenüberliegend angeordnete Stege oder Brücken (27) vorgesehen sind und dass zwischen den Längsbreitseiten des Wandlers (9) und dem Innenrahmen (26) ein Abstandsspalt ausgebildet ist.

4. Piezoelektrischer Antrieb nach einem der vorangegangenen Ansprüche,
**dadurch gekennzeichnet, dass**
der Doppelrahmen (13) aus einem metallischen Material hoher Güte besteht.

5. Piezoelektrischer Antrieb nach einem der vorangegangenen Ansprüche,
**dadurch gekennzeichnet, dass**
die Innenrahmen (26) jeweils am Wandler (9) stoffschlüssig befestigt sind.

6. System, umfassend einen piezoelektrischen Antrieb nach einem der Ansprüche 1 bis 5 und eine Schaltungsanordnung (15) zum Betreiben des piezoelektrischen Antriebs,
**dadurch gekennzeichnet, dass**
die Schaltungsanordnung einen Grund- oder Steuergenerator (39) aufweist, der unmittelbar mit einem ersten Eingang eines zweikanaligen Brückenleistungsverstärkers (41) und über einen Phasenschieber (54) mit dem zweiten Eingang des Leistungsverstärkers verbunden ist, wobei die Ausgänge des Brückenleistungsverstärkers über ein Filter (57) auf die Primärseite eines summierenden Transformators (54) führen und die Sekundärseite des Transformators einerseits an einer Rückseitenelektrode (19) und andererseits über einen Umschalter wahlweise an eines der Paare von Vorderseitenelektroden (17,18,20,21) des piezoelektrischen Wandlers (9) des Antriebs angeschlossen ist.

7. System nach Anspruch 6,
**dadurch gekennzeichnet, dass**
das Filter (57) eine in Serie geschaltete L-C-Anordnung ist.

8. System nach Anspruch 6,
**dadurch gekennzeichnet, dass**
das Filter (57) aus einer L-C-Anordnung auf der Primär- und/oder Sekundärseite des Transformators besteht und ein Signalpegelwandler (70) vorgesehen ist, dessen Ausgang auf den Steuereingang des Phasenschiebers (54) führt und dessen Eingang über einen Komparator (71) an einen Elektrodengruppenkommutator (74) angeschlossen ist, wobei der Elektrodengruppenkommutator mit jeweils dem invertierenden und dem nichtinvertierenden Komparatorausgang (72,73) in Verbindung steht.

9. System nach einem der Ansprüche 6 bis 8,
**dadurch gekennzeichnet, dass**
auf dem piezoelektrischen Wandler (9) ein Biegesensor (86) zur Bestimmung mechanischer Striktionen angeordnet ist, wobei Biegesensorelektroden (89,90) über eine Signalauswerteeinheit (96) mit einem Steuereingang des Grundgenerators (39) in Verbindung stehen.

10. System nach Anspruch 9,
**dadurch gekennzeichnet, dass**
die Signalsauswerteeinheit aus einem Phasendetektor (96) mit Phasenstützeingang (97) besteht, wobei der Steuersignalausgang des Phasendetektors zur Veränderung der Erregerfrequenz auf den Grundgenerator (39) führt, um diesen auf eine konstante, vorgegebene Phasendifferenz auch bei Temperaturschwankungen des piezoelektrischen Wandlers (9) zu steuern.

11. System nach Anspruch 9 oder 10,
**dadurch gekennzeichnet, dass**
der Biegesensor (86) zur Bestimmung der Biegekomponenten der mechanischen Erregung als dünne, einschichtige piezokeramische Platte (87) mit die gesamte Hauptoberfläche überdeckenden Elektroden (88,89) ausgeführt ist und eine bezogen auf die Querachse symmetrische Polarisation besitzt, wobei der Biegesensor starr mit einer der Wandleroberflächen zwischen Mitten- und Seitenknoten der Biegemode der Schwingungen verbunden ist.

## Claims

1. A piezoelectric drive, in particular a piezoelectric motor for generating continuous or stepwise movements, comprising a rotor (1) with a friction surface (2), a drive element (5) which may be brought into contact with same in the form of a piezoelectric exciter (8), with the exciter consisting of monolithic, plate-shaped, essentially rectangular piezoelectric transducer (9) which comprises electrode faces (10, 11), an outer mounting means (4, 6), a friction element (12) arranged on one of the end faces of the piezoelectric transducer, as well a support (13) for the piezoelectric transducer and means for resiliently pressing the friction element against the friction surface,
**characterised in that**
an elastic double frame (13) surrounding the transducer with an inner (26) and an outer frame (25) is arranged at the respective outer node of the bending vibration mode for supporting the piezoelectric transducer (9) as well as for generating the pressing force of the friction element (12),
with the inner frame being connected with each of the longitudinal small faces of the transducer (9) and the outer frame being connected with the outer mounting means (6),
and further the outer frame and the inner frame are spaced and in contact via lands or bridges (27).

2. The piezoelectric drive according to Claim 1,
**characterised in that**
the double frame (13) has a symmetric construction along its axis and the centrally arranged lands or bridges (27) connect the inner and outer frame.

3. The piezoelectric drive according to Claim 1 or 2,
**characterised in that**
two lands or bridges (27) arranged opposite to one another are provided and that a clearance gap is formed between the longitudinal wide faces of the transducer (9) and the inner frame (26).

4. The piezoelectric drive according to one of the previous claims,
**characterised in that**
the double frame (13) is made from a high quality metallic material.

5. The piezoelectric drive according to one of the previous claims,
**characterised in that**
the inner frames (26) each are adhesively attached at the transducer (9).

6. A system, comprising a piezoelectric drive according to one of Claims 1 to 5 and a circuit arrangement (15) for operating the piezoelectric drive,
**characterised in that**
the circuit arrangement comprises a basic or control generator (39) which is directly connected with a first input of a two-channel bridge power amplifier (41) and with the second input of a power amplifier via a phase shifter (54), with the outputs of the bridge power amplifier leading to the primary side of a summing transformer (56) via a filter (57), and the secondary side of the transformer being connected with a backside electrode (19), on the one hand, and selectively with one of the pairs of the front side electrode (17, 18, 20, 21) of the piezoelectric transducer (9) of the drive via a change-over switch, on the other hand.

7. The system according to Claim 6,
**characterised in that**
the filter (57) is an LC arrangement connected in series.

8. The system according to Claim 6,
**characterised in that**
the filter (57) consists of an LC arrangement on the primary and/or secondary side of the transformer and a signal level converter (70) it provided whose output leads to the control input of the phase shifter (54) and whose input is connected with an electrode group commutator (74) via a comparator (71), with the electrode group commutator being connected with the inverting and the non-inverting comparator output (72, 73), respectively.

9. The system according to one of Claims 6 to 8,
**characterised in that**
a bending sensor (86) for the determination of mechanic strictions is arranged on the piezoelectric transducer (9), with bending sensor electrodes (89, 90) being connected with a control input of the basic generator (39) via a signal evaluation unit (96).

10. The system according to Claim 9,
**characterised in that**
the signal evaluation unit consists of a phase detector (96) with a phase boosting input (97), with the control signal output of the phase detector leading to the basic generator (39) for modifying the exciter frequency, in order drive it to a constant pregiven phase difference, even with temperature variations of the piezoelectric transducer (9).

11. The system according to Claim 9 or 10,
**characterised in that**
the bending sensor (86) for the determination of the bending components of the mechanic excitation is implemented as a thin, single-layer, piezoceramic plate (87) with electrodes (88, 89) which cover the entire principal surface, and has a polarisation which is symmetric with respect to the transverse axis, with the bending sensor being rigidly connected with one of the transducer surfaces between the centre and side node bending mode of the vibrations.

## Revendications

1. Entraînement piézoélectrique, en particulier moteur piézoélectrique pour produire des mouvements continus ou par paliers, comprenant un rotor (1) présentant une surface de friction (2), un élément d'entraînement (5) susceptible d'être amené en contact avec cette surface, sous forme d'un excitateur (8) piézoélectrique, l'excitateur étant constitué par un transducteur (9) piézoélectrique monolithique en forme de plaque, sensiblement rectangulaire et présentant des surfaces d'électrodes (10, 11), comprenant une fixation extérieure (4, 6), un élément de friction (12) agencé sur une des faces frontales du transducteur piézoélectrique ainsi qu'une monture (13) pour le transducteur piézoélectrique et des moyens pour presser élastiquement l'élément de friction sur la surface de friction, **caractérisé en ce que** pour maintenir le transducteur (9) piézoélectrique ainsi que pour produire la force de friction de l'élément de friction (12), un double cadre (13) élastique entourant le transducteur, avec cadre intérieur (26) et cadre extérieur (25), est agencé sur le noeud extérieur du mode d'oscillation en flexion, le cadre intérieur étant relié avec chacun des petits côtés du transducteur (9), et le cadre extérieur étant relié à la fixation extérieure (6), le cadre extérieur et le cadre intérieur étant en outre espacés l'un de l'autre et en contact via des traverses ou des ponts (27).

2. Entraînement piézoélectrique selon la revendication 1, **caractérisé en ce que** le double cadre (13) présente une structure symétrique le long de son axe et les traverses ou les ponts (27) relient des cadres intérieurs et des cadres extérieurs agencés au milieu.

3. Entraînement piézoélectrique selon la revendication 1 ou 2, **caractérisé en ce qu'**il est prévu deux traverses ou ponts (27) agencées à l'opposé l'une de l'autre et **en ce qu'**une fente d'espacement est réalisée entre les grands côtés du transducteur (9) et le cadre intérieur (26).

4. Entraînement piézoélectrique selon l'une des revendications précédentes, **caractérisé en ce que** le double cadre (13) est en un matériau métallique de haute qualité.

5. Entraînement piézoélectrique selon l'une des revendications précédentes, **caractérisé en ce que** les cadres intérieurs (26) sont chacun fixés sur le transducteur (9) par coopération de matières.

6. Système comprenant un entraînement piézoélectrique selon l'une des revendications 1 à 5 et un agencement de circuit (15) pour faire fonctionner l'entraînement piézoélectrique, **caractérisé en ce que** l'agencement de circuit présente un générateur de base ou générateur de commande (39) qui est relié directement à une première entrée d'un amplificateur de puissance en pont (41) à deux canaux et à la deuxième entrée de l'amplificateur de puissance via un déphaseur (54), les sorties de l'amplificateur de puissance en pont menant via un filtre (57) au côté primaire d'un transformateur sommateur (54) et le côté secondaire du transformateur est branché d'une part à une électrode de face arrière (19) et d'autre part via un commutateur au choix à une des paires d'électrodes de face avant (17, 18, 20, 21) du transducteur (9) piézoélectrique de l'entraînement.

7. Système selon la revendication 6, **caractérisé en ce que** le filtre (57) est un montage LC branché en série.

8. Système selon la revendication 6, **caractérisé en ce que** le filtre (57) est constitué par un montage LC sur le côté primaire et/ou sur le côté secondaire du transformateur et **en ce qu'**il est prévu un convertisseur de niveau de signal (70) dont la sortie mène à l'entrée de commande du déphaseur (54) et dont l'entrée est branchée via un comparateur (71) à un commutateur (74) de groupes d'électrodes, le commutateur de groupes d'électrodes étant en liaison avec la sortie inverseuse (72) et la sortie non inverseuse (73) du comparateur.

9. Système selon l'une des revendications 6 à 8, **caractérisé en ce que** sur le transducteur (9) piézoélectrique est agencé un capteur de flexion (86) pour déterminer des strictions mécaniques, des électrodes de capteur de flexion (89, 90) étant en liaison via une unité d'évaluation de signal (96) avec une entrée de commande du générateur de base (39).

10. Système selon la revendication 9, **caractérisé en ce que** l'unité d'évaluation de signal est constituée par un détecteur de phase (96) avec entrée de soutien de phase (97), la sortie de signal de commande du détecteur de phase menant à modifier la fréquence d'excitation sur le générateur de base (39) pour commander celui-ci à une différence de phase constante prédéterminée même en cas de fluctuation de température du transducteur (9) piézoélectrique.

11. Système selon la revendication 9 ou 10, **caractérisé en ce que** le capteur de flexion (96) prévu pour déterminer les composants de flexion de l'excitation mécanique est réalisé sous forme de plaque piézocéramique (87) monocouche mince avec des électrodes (88, 89) recouvrant toute la surface principale et possède une polarisation symétrique par rapport à l'axe transversal, le capteur de flexion étant relié de manière rigide à une des surfaces de transducteur entre des noeuds médians et latéraux du mode de flexion des oscillations.
